(19) Europäisches Patentamt
European Patent Office
Office européen des brevets

(11) EP 1 036 428 B1

(12) **EUROPÄISCHE PATENTSCHRIFT**

(45) Veröffentlichungstag und Bekanntmachung des Hinweises auf die Patenterteilung:
**26.09.2001 Patentblatt 2001/39**

(21) Anmeldenummer: **98965648.3**

(22) Anmeldetag: **21.10.1998**

(51) Int Cl.⁷: **H01S 5/06**, H01S 5/40

(86) Internationale Anmeldenummer:
**PCT/EP98/06911**

(87) Internationale Veröffentlichungsnummer:
**WO 99/28998 (10.06.1999 Gazette 1999/23)**

(54) **VERFAHREN UND ANORDNUNG ZUR WELLENLÄNGENABSTIMMUNG EINER OPTOELEKTRONISCHEN BAUELEMENTE-ANORDNUNG**

METHOD AND DEVICE FOR TUNING THE WAVELENGTH OF AN OPTOELECTRONIC COMPONENT ARRANGEMENT

PROCEDE ET DISPOSITIF PERMETTANT D'ACCORDER LA LONGUEUR D'ONDE D'UNE STRUCTURE DE COMPOSANTS OPTOELECTRONIQUES

(84) Benannte Vertragsstaaten:
**AT BE CH DE DK ES FR GB IE IT LI NL PT SE**

(30) Priorität: **01.12.1997 DE 19755457**

(43) Veröffentlichungstag der Anmeldung:
**20.09.2000 Patentblatt 2000/38**

(73) Patentinhaber: **Deutsche Telekom AG**
**53113 Bonn (DE)**

(72) Erfinder:
- **HILLMER, Hartmut**
  **D-34128 Kasseladt (DE)**
- **KLEPSER, Bernd**
  **D-98617 Meiningen (DE)**

(56) Entgegenhaltungen:
**US-A- 5 536 085**

- **PATENT ABSTRACTS OF JAPAN vol. 014, no. 002 (E-868), 8. Januar 1989 & JP 01 251686 A (CANON INC), 6. Oktober 1989**
- **PATENT ABSTRACTS OF JAPAN vol. 009, no. 065 (E-304), 26. März 1985 & JP 59 204292 A (CANON KK), 19. November 1984**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 1 036 428 B1

Printed by Jouve, 75001 PARIS (FR)

## Beschreibung

Die Erfindung betrifft ein Verfahren zur Wellenlängenabstimmung von optoelektronischen Bauelementen einer optoelektronischen Bauelemente-Anordnung.

Die Erfindung betrifft eine optoelektronische Bauelemente-Anordnung mit zumindest zwei optoelektronischen Bauelementen. Jedem einzelnen optoelektronischen Bauelement der Bauelemente-Anordnung ist jeweils eine Widerstandsheizung zur Einstellung der charakterischen Wellenlänge des optoelektronischen Bauelements zugeordnet.

US-A-5 536 085 offenbart ein Verfahren gemäß dem Oberbegriff des Anspruchs 1 sowie eine Anordnung gemäß dem Oberbegriff des Anspruchs 9.

In zunehmendem Maße werden zur Datenübertragung beziehungsweise zur Ubertragung von Fernseh- und Rundfunkkanälen optische Übertragungssysteme eingesetzt. Im allgemeinen besteht ein solches optisches Übertragungssystem aus einem lichtführenden Wellenleiter, einem Halbleiterlaser als Lichterzeuger und einem Lichtdetektor. Der Halbleiterlaser strahlt dabei Licht mit einer bestimmten, charakteristischen Wellenlänge aus. Diese charakteristische Wellenlänge ist im wesentlichen abhängig vom eingesetzten Material, läßt sich aber beispielsweise durch thermische Einwirkung innerhalb eines bestimmten Wellenlängenbereichs einstellen. Zur Erhöhung der über einen Wellenleiter übertragbaren Datenmenge lassen sich mehrere einem Wellenleiter zugeordnete Halbleiterlaser verwenden, die mit unterschiedlichen Wellenlängen arbeiten. Hierbei ist es jedoch notwendig, daß die Wellenlängen sehr genau eingehalten werden, so daß am Ende der Übertragung eine eindeutige Differenzierung der Daten möglich ist.

Da die charakteristische Wellenlänge von Halbleiterlasern herstellungsbedingt innerhalb eines Toleranzbereiches differiert, müssen die Halbleiterlaser vor dem Einsatz zur Datenübertragung abgestimmt werden. Hierzu bedient man sich beispielsweise sogenannter Widerstandsheizungen, die durch thermische Einwirkung die charakteristische Wellenlänge eines Halbleiterlasers verändert. Die Abstimmung erfolgt im allgemeinen durch Einstellen der an der Widerstandsheizung anliegenden Spannung, wobei hier jeder Widerstandsheizung und damit jedem optoelektronischen Bauelement der Bauelemnte-Anordnung jeweils eine Spannungsquelle zugeordnet ist.

Dies hat jedoch den Nachteil, daß ein sehr aufwendiger Aufbau notwendig wird. Desweiteren ist eine spätere Abstimmung der Anordnung in einfacher Weise nicht mehr möglich.

Die Aufgabe der vorliegenden Erfindung besteht deshalb darin, ein Verfahren zur Abstimmung von optoelektronischen Bauelementen anzugeben, das einfach ist und sich mit minimalem Kostenaufwand realisieren läßt. Desweiteren ist die zur Realisierung des Verfahrens benötigte Anordnung anzugeben.

Die Aufgabe wird erfindungsgemäß durch ein Verfahren gelöst, welches ebenfalls auf dem Prinzip der thermischen Änderung der Widerstandsheizungen der optoelektronischen Bauelemente der betreffenden optoelektronischen Bauelemente-Anordnung beruht.

Die Aufgabe der Erfindung wird durch ein Verfahren gelöst, das die Merkmale des Anspruchs 1 umfaßt.
Die Bauelemente-Anordnung wird durch eine Lösung realisiert, die die Merkmale des Anspruchs 9 aufweist. Das Verfahren beruht darauf, daß im ersten Verfahrensschritt für jedes optoelektronische Bauelement der optoelektronischen Bauelemente-Anordnung die Wellenlänge erfaßt wird. Anhand des Vergleichs der erfaßten Wellenlänge mit der gewünschten charakteristischen Wellenlänge wird für jedes optoelektronische Bauelement der optoelektronischen Bauelemente-Anordnung die Abweichung von der gewünschten charakteristischen Wellenlänge ermittelt. Anschließend wird erfindungsgemäß eine dem jeweiligen optoelektronischen Bauelement zugeordnete Widerstandsanordnung, abhängig von der ermittelten Wellenlängenabweichung, verändert. Die Widerstandsanordnung, welche der Heizung des optoelektronischen Bauelements vorgeschaltet ist, beeinflußt über ihren Gesamtwiderstand die Heizleistung der Heizung des optoelektronischen Bauelements. Der Gesamtwiderstand der Widerstandsanordnung wird so eingestellt, daß über die Heizleistung die gewünschte charakteristischen Wellenlänge des betreffenden optoelektronischen Bauelements erzielt wird. Diese Prozedur wird für jedes optoelektronische Bauelement der optoelektronischen Bauelemente-Anordnung einzeln durchgeführt.
Das erfindungsgemäße Verfahren erlaubt eine sehr einfache Einstellung der optoelektronischen Bauelemente einer Bauelemente-Anordnung, beispielsweise einer Halbleiterlaserzeile. Insbesondere läßt sich das Verfahren vollautomatisch durchführen, was große Vorteile bei der Verwendung von optoelektronischen Bauelementen in größerem Umfang hat.

Die erfindungsgemäße Bauelemente-Anordnung umfaßt erfindungsgemäß neben einer gemeinsamen Spannungsquelle $U_0$ Widerstandsanordnungen RM. Dabei ist jedem optoelektronischen Bauelement der Bauelemente-Anordnung eine separate Widerstandsanordnung RM zugeordnet. Die Widerstandsanordnung RM ist jeweils zwischen gemeinsamer Spannungsquelle $U_0$ und Widerstandsheizung H angeordnet, das heißt, jeder Widerstandsheizung H ist eine separate Widerstandsanordnung RM vorgeschaltet. Jede Widerstandsanordnung RM besteht aus einem Netzwerk von Widerständen R. Damit läßt sich die Heizleistung für jedes optoelektronische Bauelement der optoelektronischem Bauelemente-Anordnung sehr einfach durch entsprechende Veränderungen im Widerstandsnetzwerk einstellen. Da alle Widerstandsanordnungen RM über eine einzige Spannungsquelle $U_0$ gespeist werden, entfällt ein beträchtlicher schaltungstechnischer Aufwand und es werden damit Kosten eingespart. Ein weiterer Vorteil liegt darin begründet, daß in sehr einfacher Weise auch nachträglich eine Abstimmung der charakteristischen Wellenlänge der optoelektronischen Bauelemente durch Verändern des Gesamtwiderstandes und damit der Heizleistung durchführbar ist.

Eine vorteilhafte Weiterbildung der Erfindung besteht darin, die Widerstandsanordnung RM als Widerstandsarray auszubilden, welches mehrere systematisch nach Widerstandswerten geordnete Widerstandselemente umfaßt. Vorzugsweise weist die Widerstandsanordnung RM eine oder mehrere Reihen von Kontaktfelder K auf, wobei die Widerstände der Widerstandsanordnung RM zwischen einzelnen Kontaktfeldern K angeordnet sind. Durch schalten bzw. überbrücken von Kontaktfeldern K läßt sich der Gesamtwiderstand der Widerstandsanordnung RM und damit die Heizleistung der Heizung des optoelektronischen Bauelements verändern. Da die Kontaktfelder K und die Widerstände nach logischen Gesichtspunkten angeordnet sind, kann die Heizleistung in einfacher Art und Weise durch beschalten von Kontaktfeldern K eingestellt werden, wobei sich die konkret zu schaltenden Verbindungen aus der Systematik der Matrix festlegen lassen. Gleichzeitig beinhaltet das erfindungsgemäße Verfahren die Möglichkeit, auch bei Bedarf jederzeit eine notwendige Anpassung der Heizleistung vornehmen zu können.

Weitere vorteilhafte Ausgestaltungen der erfindungsgemäßen Anordnung ergeben sich aus den Unteransprüchen.

Die Erfindung wird nun anhand von Ausführungsbeispielen mit Bezug auf die Zeichnungen näher erläutert. Dabei zeigen:

| | |
|---|---|
| Figur 1 | ein Blockdiagramm einer optoelektronischen Bauelemente-Anordnung, |
| Figur 2a | eine schematische Darstellung einer Widerstandseinrichtung, |
| Figur 2b | ein Schaltbild der Widerstandseinrichtung, |
| Figur 2c | Darstellung, wie sich die Heizleistungen verschiedener Kanäle gegenseitig beeinflussen, |
| Figur 3 | ein erstes Ausführungsbeispiel einer Bauelemente-Anordnung, |
| Figur 4a | ein weiteres Ausführungsbeispiel einer Bauelemente-Anordnung, |
| Figur 4b bis 4d | drei Diagramme zur Bestimmung der Heizleistung, |
| Figur 5a | ein weiteres Ausführungsbeispiel einer Bauelemente-Anordnung, |
| Figur 5b | ein Diagramm zur Berechnung der Heizleistung, |
| Figur 6 | ein weiteres Ausführungsbeispiel einer Bauelemente-Anordnung, |
| Figur 7 | ein weiteres Ausführungsbeispiel einer Bauelemente-Anordnung, |
| Figur 8 | ein weiteres Ausführungsbeispiel einer Bauelemente-Anordnung, |
| Figur 9 | ein weiteres Ausführungsbeispiel einer Bauelemente-Anordnung, |
| Figur 10 | ein weiteres Ausführungsbeispiel einer Bauelemente-Anordnung, |
| Figur 11 | ein weiteres Ausführungsbeispiel einer Bauelemente-Anordnung, und |
| Figur 12a | Ausführungsbeispiel mit Widerstandsanordnung auf der Bauelementezeile |
| Figur 12b | ein Diagramm zur Veranschaulichung des Verfahrens. |
| Figur 13 | ein Ausführungsbeispiel mit Stromquelle |

In Figur 1 ist eine Bauelemente-Anordnung 1 dargestellt, die eine Anzahl von Halbleiterlasern L1 bis Ln umfaßt. Der grundsätzliche Aufbau einer solchen Halbleiterlaserzeile ist bekannt, weshalb an dieser Stelle auf deren genaue Beschreibung verzichtet wird. Zur gleichzeitigen Übertragung von Daten in einem optischen Datenübertragungssystem arbeiten die Halbleiterlaser L1-Ln mit. unterschiedlichen Wellenlängen beziehungsweise Frequenzen.

Herstellungsbedingt strahlen die Halbleiterlaser L1-Ln nicht immer mit der gewünschten Wellenlänge aus. Vor und/ oder während der Inbetriebnahme erfolgt deshalb eine Abstimmung auf die gewünschte Wellenlänge durch Verändern der charakteristischen Wellenlänge, wobei im vorliegenden Fall der thermische Effekt ausgenutzt wird. Durch entsprechende individuelle Beaufschlagung der Halbleiterlaser L1-Ln mit einer bestimmten Temperatur, läßt sich die jeweilige Wellenlänge innerhalb eines bestimmten Bereichs variieren.

Hierzu ist jedem Halbleiterlaser L1 bis Ln zumindest eine Widerstandsheizung H1 bis Hn zugeordnet. Jede der Widerstandsheizungen H1 bis Hn besteht aus einem Stromleiter, der einen entsprechend hohen Widerstand aufweist und bei Anlegen einer Spannung Wärme entwickelt und im jeweiligen Halbleiterlaser Ll-Ln ein Temperaturfeld erzeugt. Zur Erzeugung des gewünschten Temperaturfeldes muß in vielen Fällen die Heizleistung erst eingestellt werden. Dazu ist jede Widerstandsheizung H1-Hn erfindungsgemäß mit einer separaten Widerstandsanordnung RM1-RMn verbunden. Alle Widerstandsanordnungen RM1-RMn sind mit einer gemeinsamen Spannungsquelle $U_0$ verbunden und werden von ihr gespeist. Die Widerstandsanordnungen RM1-RMn sind vorzugsweise als Widerstandsarrays ausgebildet, welche sich aus einzelnen Widerständen zusammensetzen. Eine gezielte Manipulation der einzelnen Widerstände führt zu einer gezielten Veränderung des Gesamtwiderstandes der als Widerstandsarray ausgebildeten Widerstandsanordnung. Durch die Veränderung des Gesamtwiderstandes der einzelnen Widerstandsanordnungen RM1-RMn wird eine Veränderung des durch die Widerstandsheizungen H1-Hn fließenden Stroms und damit eine Änderung der Heizleistung der einzelnen Widerstandsheizungen H1-Hn bewirkt. Über die Änderung der Heizleistung der einzelnen Widerstandsheizungen H1-Hn erfolgt die individuelle Änderung der Wellenlänge bis die gewünschte charakteristische Wellenlänge für jeden einzelnen Halbleiterlaser L1-Ln eingestellt ist.

Die Einstellung der Widerststände der Widerstandsanordnungen RM1-RMn auf bestimmte Widerstandswerte erfolgt elektrisch, optisch und/oder durch elektromagnetische Wellen.

Die Widerstandsanordnungen RM1-RMn lassen sich einerseits auf einem die Halbleiterlaser L1-Ln tragenden Träger/ Isolator anordnen. Desweiteren ist es möglich, die Widerstandsanordnungen RM1-RMn getrennt von den Halbleiterlasern L1-Ln anzuordnen, beispielsweise an einer später sehr leicht zugänglichen Stelle der gesamten Einheit zur Datenübertragung.

Wie bereits erwähnt, läßt sich die charakteristische Wellenlänge $\lambda_q$ jedes einzelnen optoelektronischen Bauelements, wie beispielsweise bei den Halbleiterlasern L1-Ln, über die Temperatur jedes einzelnen Halbleiterlasers L1-Ln und somit über die Heizleistung $P_q$ beziehungsweise den Heizstrom $I_q$ durch die Widerstandsheizungen H1-Hn individuell einstellen. Die Grundlage für jeden Kanal q, mit $q \in [1\text{-}n]$, den Heizstrom individuell einzustellen, bildet eine matrixartige Anordnung der Widerstandsanordnungen RM1-RMn.

In Figur 2a ist eine derartige Widerstandsanordnung für den Kanal q dargestellt. Die Widerstandsanordnung besteht aus Kontaktfeldern $K_{q,i,j}$ mit den Koordinaten (i,j), wobei $i \in [1, r]$ und $j \in [1, s]$ ist, q die Bauelemente-Nummer (Kanal) angibt und r bzw. s die Größe der matrixartigen Widerstandsanordnung in y- bzw. x-Richtung ist. Die eingezeichneten Indizes j und i bezeichnen die Spalten- und Zeilennummern. Diese matrixartige Anordnung von Kontaktfeldern wird im folgenden auch als Kontaktmatrix bezeichnet. Die Kontaktfelder sind über ohmsche Widerstände $R_{q,i,j\to q,k,l}$ gekoppelt, wobei $R_{q,i,j\to q,k,l}$ einen Widerstand zwischen den Kontaktfeldern $K_{q,i,j}$ und $K_{q,k,l}$ bezeichnet. Die Widerstandswerte der ohmschen Widerstände umfassen Werte $R_{q,i,j\to q,k,l}$ = 0 Ohm (Kurzschluß) bis $R_{q,i,j\to q,k,l} \to\infty$ (keine elektrisch leitende Verbindung oder Isolator). Die Kontaktfelder $K_{q,t,u}$ und $K_{q,v,w}$ mit $(t, u) \neq (v,w)$ sind mit einer elektrischen Spannungsquelle $U_0$ verbunden, die zwischen den Kontaktfeldern eine Potentialdifferenz U(t) beliebigen zeitlichen Verlaufs erzeugt. Die elektrischen Verbindungen der Spannungsquelle $U_0$ mit den Kontaktfeldern $K_{q,t,u}$ und $K_{q,v,w}$ werden im folgenden mit LQ bezeichnet. Eine elektrische Verbindung LQ besteht aus einer Zahl $f \geq 1$ im mathematischen Sinne mehrfach zusammenhängender elektrisch leitfähiger Gebiete, die elektrisch miteinander verbunden sind. Diese Gebiete enthalten eine Anzahl $g \geq 0$ elektrisch leitender Gebiete der Widerstandheizung Hq eines Kanals q und eine Anzahl $h \geq 0$ elektrisch leitender Gebiete der matrixartigen Anordnung aus Kontaktfeldern.

Die Kontaktfelder $K_{q,a,b}$ und $K_{q,c,d}$ mit $(a,b) \neq (c,d)$ sind über eine elektrisch leitende Verbindung mit der Widerstandsheizung Hq derart verbunden, daß eine Potentialdifferenz zwischen den Punkten $K_{q,a,b}$ und $K_{q,c,d}$ einen elektrischen Stromfluß durch die Widerstandsheizung Hq hervorruft, falls der Widerstandswert $R_q$ der Widerstandsheizung Hq endlich groß ist.

Die Anordnung aus Spannungsquelle $U_0$, elektrischen Verbindungen LQ, matrixförmiger Anordnung aus Kontaktfeldern, den ohmschen Widerständen $R_{q,i,j\to q,k,l}$ zwischen den Kontaktfeldern $K_{q,i,j}$ und $K_{q,k,l}$ wird erfindungsgemäß derart manipuliert beziehungsweise abgestimmt, daß sich an der elektrischen Widerstandsheizung Hq eine Heizleistung $P_q$ einstellt, die durch die thermische Ankopplung der Widerstandsheizung Hq am Halbleiterlaser Lq eine Temperaturänderung $\triangle T_q$ am Halbleiterlaser Lq hervorruft. Diese Temperaturänderung bewirkt eine Wellenlängenverschiebung $\Delta\lambda_q$ der charakteristischen Wellenlänge des Kanals q.

Die individuelle Einstellung der Wellenlänge $\lambda_q$ des Kanals q läuft nach folgendem Verfahren ab:

Zu Beginn des Verfahrens wird eine Heizleistung $P_q \geq 0$ eingestellt, aus der sich eine Wellenlänge $\lambda_q$ ergibt. Das Ziel ist, die Heizleistung derart einzustellen, daß die Wellenlänge $\lambda_{q,s}$ beträgt.

Die Heizleistung der Widerstandsheizung wird in einem Bereich variiert, in dem die damit verbundene Wellenlängenänderung den Bereich der gewünschten Wellenlänge $\lambda_{q,s}$ abdeckt. Aus dieser Messung ergibt sich ein funktioneller Zusammenhang $\lambda_q(P_q)$. Entsprechend läßt sich aus diesem Zusammenhang für eine Wellenlänge $\lambda_{q,s}$ die Heizleistung $P_q$ bestimmen. Die gewünschte Heizleistung $P_q$ läßt sich durch verändern der Widerstandsanordnung RMq einstellen. Auch durch Einstellen der Spannung an der Spannungsquelle $U_0$ läßt sich die Heizleistung $P_q$ variieren, wobei jedoch entsprechend auch die Heizleistung der anderen optoelektronischen Bauelemente verändert wird. Durch die Größe der angelegten Spannung an den Kontaktfeldern $K_{q,t,u}$ und $K_{q,v,w}$, die Dimensionierung und Anordnung der Widerstände $R_{q,i,j \rightarrow q,k,l}$ und durch Überbrückungen (Kurzschlüsse) zwischen den Kontaktfeldern sowie Bemessung der Größe des Heizwiderstandes $P_q$ der Widerstandsheizung Hq wird der maximale Betrag der Leistungsvariation $\triangle P_q = P_{q,max}-P_{q,min}$ eines Kanals q festgelegt. Aus dieser Leistungsvariation $\triangle P_q$ ergibt sich eine maximale Wellenlängenvariation $\triangle\lambda_{q,\,max}$.

Eine weitere Möglichkeit, die charakteristische Wellenlänge einzustellen, besteht darin, die Heizleistung $P_q$ auf einen bestimmten Wert $P \geq 0$ einzustellen und die dazugehörige Wellenlänge zu messen. Dann wird auf der Grundlage von abgespeicherten Erfahrungswerten zu dem funktionellen Zusammenhang $\lambda_q(P_q)$ die Heizleistung $P_q$ verändert.

Es ist auch denkbar, die Heizleistung $P_q$ nacheinander auf zwei Werte einzustellen und jeweils die zugehörige Wellenlänge zu messen. Anschließend wird der Verlauf des funktionellen Zusammenhangs $\lambda_q(P_q)$ durch Interpolation und/oder Extrapolation der zuvor ermittelten Wellenlängen berechnet und entsprechend die Heizleistung $P_q$ verändert.

Ebenfalls ist es denkbar, die Heizleistung Pq in einem Intervall in bestimmten Schritten $\triangle P$ zu variieren und die entsprechende Wellenlänge zur Erstellung des funktionellen Zusammenhangs $\lambda_q\ (P_q)$ zu messen und anhand des ermittelten Zusammenhangs die Heizleistung $P_q$ zu verändern.

Selbstverständlich ist es auch möglich, die Heizleistung $P_q$ kontinuierlich zu variieren, bis die gewünschte charakteristische Wellenlänge erreicht ist.

Bei der Einstellung der Heizleistung Pq muß für die Widerstandswerte der Verbindungen LQ zwischen der Spannungsquelle $U_0$ und der matrixartigen Anordnung von Kontaktfeldern $K_{q,i,j}$ -$K_{q,k,l}$ sowie dem Innenwiderstand der Spannungsquelle $U_0$ folgende Forderung erfüllt sein: Haben bei einer Bauelemente-Anordnung von n Kanälen mit n Widerstandsheizungen und n Anordnungen von Kontaktfeldern eine Anzahl von n-1 Widerstandsheizungen H eine Heizleistung $P_{e,min}$ und eine beliebige Widerstandsheizung $H_s$ die Heizleistung $P_s$ mit $P_{s,min}<P_s<P_{s,max}$ und $s \neq e$, dann müssen die elektrischen Verbindungen LQ der Spannungsquelle $U_0$ mit den Kontaktfeldern der einzelnen Kanäle q sowie der Innenwiderstand der Spannungsquelle $U_0$ derart dimensioniert sein, daß bei einer Variation der Heizleistungen der n-1 Kanäle um $\triangle P_e$, also von $P_{e,min}$ nach $P_{e,max}$, die Heizleistung der Widerstandsheizung $H_s$ um einen Wert $\triangle P_{s,Fehler}<\varepsilon_s \bullet \triangle P_s$ variiert, mit einem Wert $0<\varepsilon_s<1$, der frei wählbar ist, jedoch möglichst klein sein sollte, um eine gegenseitige Beeinflussung der Kanäle zu minimieren.

In Figur 2b ist das Schaltbild eines Ausführungsbeispiels mit drei Widerstandsheizungen dargestellt. Die matrixartigen Anordnungen von Kontaktfeldern ist in diesem einfachen Fall derart gestaltet, daß sie zu Gesamtwiderständen (im folgenden mit Vorwiderständen $R_{V1}$-$R_{V3}$ bezeichnet), die zum Heizwiderstand $R_{H1}$-$R_{H3}$ in Serie geschaltet sind, zusammengefaßt werden können. Die elektrischen Verbindungen LQ der Spannungsquelle $U_0$ mit den Kontaktfeldern zu den Gesamtwiderständen $R_{V1}$-$R_{V3}$ und Heizwiderständen $R_{H1}$-$R_{H3}$ haben einen Leitungswiderstand $R_{L1}$-$R_{L3}$. Der Innenwiderstand der Spannungsquelle $U_0$ ist im Widerstand $R_{L1}$ enthalten.

Die Widerstandswerte der Vorwiderstände $R_{V1}$-$R_{V3}$ und Heizwiderstände $R_{H1}$-$R_{H3}$ werden entsprechend der nötigen Heizleistungen $P_1$ - $P_3$ beziehungsweise Wellenlängenverschiebung und der Größe der zur Verfügung stehenden Spannung $U_0$ dimensioniert. Die Leitungwiderstände $R_{L1}$-$R_{L3}$ müssen obige Forderung erfüllen. Die Leistungen der Heizwiderstände $R_{H1}$-$R_{H3}$ ergeben sich aus:

$P_q = I_q^2 R_{Hq}$ mit q = 1,2,3 und $R_{Hq}$ = Widerstand der q-ten Heizung $H_q$

und den Strömen

$$I_1 = \frac{U_o}{R_{ges}}\left(1-\frac{R_{L1}}{R_{ges}}\right)$$

$$I_2 = \frac{U_O}{R_\beta}\left[1-\frac{R_{L1}}{R_{ges}}-\frac{R_{L2}}{R_{ges}}+\frac{R_{L2}}{R_\gamma}\left(1-\frac{R_{L1}}{R_{ges}}\right)\right]$$

$$I_3 = \frac{U_o}{R_\alpha + R_{L3}}\left[1 - \frac{R_{L1}}{R_{ges}} - \frac{R_{L2}}{R_{ges}} + \frac{R_{L2}}{R_\gamma}\left(1 - \frac{R_{L1}}{R_{ges}}\right)\right]$$

und

$R_a = R_{L3} + R_{V3} + R_{H3}$
$R_\beta = R_{V2} + R_{H2}$
$R_y = R_{V1} + R_{H1}$
$R_{ges}$ = Gesamtwiderstand

In Figur 2 c ist die oben genannte Forderung für Kanal 1 dargestellt. Die Heizleistung $P_1$ von Kanal 1 hat einen beliebigen Wert innerhalb von $\Delta P_1$. Die restlichen Kanäle 2 und 3 haben eine Heizleistung von $P_{2,min}$ beziehungsweise $P_{3,min}$. Wird die Heizleistung der Kanäle 2 und 3 auf $P_{2,max}$ beziehungsweise $P_{3,max}$ erhöht, so muß die Abweichung von $P_1$ kleiner sein als $\varepsilon_1 \bullet \Delta P_1$.

Im folgenden wird die Berechnung der Widerstände $R_{L1}$ bis $R_{L3}$ kurz dargestellt:

$$\frac{\Delta P_{1,Fehler}}{\Delta P_1} = \frac{P_1^{(min)}(R_{V1},R_{L1},R_{L2},R_{L3})\text{-}P_1^{(max)}(R_{V1},R_{L1},R_{L2},R_{L3})}{\Delta P_1} < \varepsilon_1$$

für beliebiges $R_{V1}$

$$\frac{\Delta P_{2,Fehler}}{\Delta P_2} = \frac{P_2^{(min)}(R_{V2},R_{L1},R_{L2},R_{L3})\text{-}P_2^{(max)}(R_{V2},R_{L1},R_{L2},R_{L3})}{\Delta P_2} < \varepsilon_2$$

für beliebiges $R_{V2}$

$$\frac{\Delta P_{3,Fehler}}{\Delta P_3} = \frac{P_2^{(min)}(R_{V3},R_{L1},R_{L2},R_{L3})\text{-}P_3^{(max)}(R_{V3},R_{L1},R_{L2},R_{L3})}{\Delta P_3} < \varepsilon_2$$

für beliebiges $R_{V3}$
mit

$P_q^{(min)}$: Heizleistung des Kanals q, wobei die restlichen Kanäle eine Heizleistung $P = P_{s,min}$ haben.

$P_q^{(max)}$: Heizleistung des Kanals q, wobei die restlichen Kanäle eine Heizleistung $P = P_{s,max}$ heben.

Aus obigen drei Gleichungen können die Maximalwerte der Leitungswiderstände $R_{L1}$, $R_{L2}$, $R_{L3}$ berechnet werden.

Eine entsprechende Umsetzung der vorgenannten Ausführungen in eine Bauelemente-Anordnung ist in den Figuren 3 bis 11 dargestellt, die im folgenden näher beschrieben werden.

Figur 3 zeigt eine Bauelemente-Anordnung 1, die drei Bauelemente, vorzugsweise Halbleiterlaser, L1, L2 und L3 umfaßt. Der Aufbau der Anordnung selbst ist zweigeteilt, wobei im ersten Teil die drei Halbleiterlaser L1 bis L3 angeordnet sind. Desweiteren umfaßt der erste Teil der Anordnung Widerstandsheizungen H1 bis H6 sowie einen Teil der Kontaktfelder der Kontaktmatrix (K1-K4; K13-K16; K25-K28), wobei H1, H2 und K1-K4 zu Kanal 1 gehören, H3, H4 und K13-K16 Kanal 2 zugeordnet sind und H5, H6 sowie K25-K28 Kanal 3 zugeordnet sind. Die Widerstandsheizungen H1-H6 sind so angeordnet, daß sie in thermischen Kontakt zu den ihnen zugeordneten Halbleiterlaser L1 bis L3 stehen.

Der zweite Teil des Aufbaus besteht aus einem Isolator, auf dem sich für jeden Kanal, das heißt für jeden Halbleiterlaser L1 bis L3 der zweite Teil der Kontaktfelder der Kontaktmatrix befindet (K5 bis K12 für Kanal 1, K 17 bis K24 für Kanal 2 und K29 bis K36 für Kanal 3). Im vorliegenden Fall besteht die Kontaktmatrix aus einer eindimensionalen Matrix mit zwölf Feldern. Die Zuleitungen LQ zur Spannungsquelle $U_0$ befinden sich am oberen Rand der Laserzeile und am unteren Rand der Kontaktzeile. Die Zuleitungen umfassen die Bereiche: A0, B, A1, K25, B, K26, A2, K13, B, K14, A3, K1, B, K2 sowie auf den Isolaten A4, K36. A5, K24, A6, K12, wobei B Bondverbindungen sind.

Die Zuleitungen enthalten somit Gebiete der Kontaktmatrizen.

Neben den Kontaktmatrizen befinden sich auf der Kontaktanordnung weitere Kontaktfelder $K_{L1}$ bis $K_{L3}$, die über elektrisch leitende Bondverbindungen B mit den Kontakten der Laserzeilen L1-L3 verbunden sind. Die Kontaktfelder K5 bis K12 von Kanal 1, K17 bis K24 von Kanal 2 und K29 bis K36 von Kanal 3 der Kontaktmatrizen sind durch räumlich verteilte Widerstandsanordnungen mit den Widerständen R1-R7; R8-R14 und R15-R21 elektrisch leitend verbunden.

In Figur 3 sind sie als schwarze Schleifen dargestellt. Das Kontaktfeld K4 ist mit Kontaktfeld K5 über eine Bondverbindung elektrisch verbunden. Gleiches gilt für die Kontaktfelder K16 und K17 sowie K28 und K29. Die Versorgungsspannung der Widerstandsheizung wird zwischen den Bereichen A4 und A0 angelegt, was durch einen Pfeil angedeutet ist.

Die Einstellung der Widerstandsheizungen H1-H6 auf eine bestimmte Heizleistung $P_q$ erfolgt durch das Verändern der Widerstände zwischen den Kontakten der Kontaktmatrix, was durch zusätzliche elektrische Verbindungen oder durch Verändern der schleifenförmigen Widerstandsanordnungen erzielt werden kann.

Die während des Abstimmungsverfahrens notwendige Variation der Heizleistung wird durch eine variable Spannung an der Spannungsquelle $U_o$ eingestellt.

Das in Figur 4a gezeigte Ausführungsbeispiel folgt in wesentlichen Teilen dem Beispiel in Figur 3. Es unterscheidet sich durch die Anordnung der Kontaktmatrize, die in diesem Fall aus jeweils 11 Kontaktfeldern besteht (K1 bis K11 für Kanal 1, K12 bis K22 für Kanal 2 und K23 bis K33 für Kanal 3). Zwischen den Kontaktfeldern K6 bis K10 und dem Kontaktfeld K11, K17 - K21 und K22 sowie K28 - K32 und K33 befinden sich ohmsche Widerstände mit den Werten:

R1 = R6 = R11 = $^1/_1 \cdot$ R,
R2 = R7 = R12 = $^1/_2 \cdot$ R,
R3 = R8 = R13 = $^1/_4 \cdot$ R,
R4 = R9 = R14 = $^1/_8 \cdot$ R,
R5 = R10 = R15 = $^1/_{16} \cdot$ R,

wobei der Widerstand R durch den maximal und minimal einzustellenden Widerstand festgelegt ist.

Es handelt sich somit um eine binäre Kodierung der Widerstandswerte, mit der es möglich ist, einen Widerstandsbereich von R bis $R/2^i$ aufzuspannen, wobei i die Zahl der Widerstände pro Kanal ist. Mit fünf Widerständen lassen sich so einunddreißig verschiedene Widerstandswerte einstellen, indem beispielsweise für den Kanal 1 elektrisch leitende Verbindungen von dem Kontaktfeld K5 zu den Kontaktfeldern K6 bis K10 hergestellt werden. Soll zum Beispiel der Widerstandswert 1/6 · R für Kanal 1 eingestellt werden, so sind, wie in Figur 4a am Bauelement L1 ausgeführt, der Widerstand R2 = ½ · R und der Widerstand R3 = □ · R parallel zu schalten. Bei Bauelement L2 ist ein Widerstandswert von 1/25 · R und bei Bauelement L3 ein Widerstandswert von 1/10 · R eingestellt.

Für den Fall, daß $U_0$ = 2.5 V,R = 480 Ohm und $R_H$ = 20 Ohm ist, ist in Figur 4b der Heizleistungsverlauf auf der linken Ordinatenachse in Abhängigkeit von dem eingestellten Index dargestellt. Der Widerstandswert ergibt sich zu $R_{res}$ = $R/_{Index}$. Die Leistung berechnet sich gemäß:

$$P(R) = \frac{U_o^2}{(R_{res} + R_H)} R_H$$

mit $R_{res}$ als dem resultierenden Widerstand.

Auf der rechten Ordinatenachse der Figur 4b ist die relative Schrittweite aufgetragen. Eine relative Schrittweite von Eins entspricht der Schrittweite des linearen Zusammenhangs zwischen der Heizleistung und des eingestellten Index. Durch die Dimensionierung der Heizwiderstände H1 - H6, der Spannung $U_o$ sowie des Widerstandes R ist eine gute Übereinstimmung mit dem linearen Verlauf erzielt worden.

Es kann von Vorteil sein, die Heizleistung $P_q$, zum Beispiel für hohe Heizleistungen, in überproportional kleinen (großen) Schrittweiten einzustellen, wie es in Figur 4c (Figur 4d) durch die Wahl der Versorgungsspannung und des Wertes für R geschehen ist. Für den Fall großer Schrittweiten bei hohen Heizleistungen (Figur 4d) beträgt die Heizspannung 20 V und der Wert von R = 8kOhm. Im Fall kleiner Schrittweiten bei hohen Heizleistungen beträgt die Heizspannung 1,5 V und der Wert für R = 40 Ohm.

Figur 5a zeigt eine Variation von Figur 3. Die schleifenförmigen Widerstandsverteilungen von Fig.3 sind in Fig.5a als gerade Widerstandsanordnung RI ausgeführt. Die Kontaktfelder K5 bis K12 greifen beispielsweise für Kanal 1 den Widerstand RI an unterschiedlichen Stellen ab. Auch bei diesem Beispiel können die resultierenden Widerstandswerte binär kodiert werden, sofern die Widerstände zwischen zwei benachbarten Kontaktfeldern aus K5 bis K12 für Kanal 1, K17 bis K24 für Kanal 2 und K29 bis K36 für Kanal 3 dimensioniert sind, wie beispielhaft für Kanal 1 gezeigt.

R1 = Widerstand zwischen K5 und K6 = R
R2 = Widerstand zwischen K6 und K7 = R · 2
R3 = Widerstand zwischen K7 und K8 = R · 4
R4 = Widerstand zwischen K8 und K9 = R · 8
R5 = Widerstand zwischen K9 und K10 = R · 16
R6 = Widerstand zwischen K10 und K11 = R · 32
R7 = Widerstand zwischen K11 und K12 = R · 64

Zum Beispiel ergibt sich für Halbleiterlaser L1 ein resultierender Widerstand von R1 + R3 + R4 + R6. Entsprechendes gilt für die restlichen Kanäle.

Figur 5b zeigt den Leistungsverlauf für den Fall der binären Kodierung. Anhand von Kanal 2 wird gezeigt, wie durch beliebig überschneidende Verbindungen zwischen den Kontaktfeldern, zum Beispiel durch Verbindungen zwischen den Kontaktfeldern K17 und K19 sowie K18 und K20, weitere Gesamtwiderstandswerte realisiert werden können.

In Figur 6 ist ein weiteres Ausführungsbeispiel einer Bauelemente-Anordnung gezeigt, wobei zur Einstellung der Heizleistung $P_q$ sechs Widerstände pro Kanal (R1 bis R6 für Kanal 1; R7 bis R12 für Kanal 2 und R13 bis R18 für Kanal 3) zur Verfügung stehen. Über die Kontaktfelder K5 bis K18 (beispielsweise für Kanal 1) können die Widerstände über Bondverbindungen B beliebig miteinander verbunden werden.

Die in Figur 7 dargestellte Kontaktmatrix besteht aus 6 Kontaktfeldern pro Kanal. Die Felder K5 und K6 (für Kanal 1) sind mittels einer abstimmbaren Widerstandsanordnung elektrisch leitend miteinander verbunden. Die Widerstandsanordnung setzt sich aus zwei Gebieten S1 und S2 zusammen, die wiederum aus einem Gebiet mit elektrisch leitendem Material X (Kreuzschraffur) und einem isolierenden Bereich mit einem Isolator Y (weiß) bestehen. Durch das Aufbringen eines hochleitfähigen Materials I(schwarz), zum Beispiel Lot auf die Bereiche S1 und S2, wird der Gesamtwiderstand zwischen den Kontaktfeldern verkleinert. Der Bereich S2 dient zur Grobeinstellung und der Bereich S1 zur Feinabstimmung der Heizleistung.

Das Ausführungsbeispiel gemäß Figur 8 ist gegenüber jenem gemäß Figur 7 dahingehend abgeändert, daß die Abstimmung durch Verändern des Widerstandes von beliebig geformten Gebieten, die als unterschiedlich gekennzeichnete Flächen dargestellt sind und unterschiedliche elektrische Leitfähigkeiten besitzen. Diese Widerstände RI-RV bestehen aus unterschiedlichem Widerstandsmaterial. Die Widerstandswerte der Widerstände RI-RV lassen sich zum Beispiel durch gezielte Materialveränderung, vorzugsweise Materialab- oder Materialauftrag auf den gewünschten Widerstandswert einstellen.

Materialabtrag bzw. Materialauftrag kann beispielsweise durch Laserablation realisiert werden. Weiterhin ist es möglich, den Widerstandswert der Widerstände RI-RV durch thermische Behandlung, chemische Behandlung oder elektrochemische Behandlung zu ändern. Weitere Möglichkeiten zur Änderung des Widerstandswertes werden in der Beeinflussung durch Teilchenimplantation, elektromagnetische Strahlung bzw. Teilchenstrahlung oder durch ein elektrisches Signal gesehen.

Das Ausführungsbeispiel gemäß Figur 9 unterscheidet sich von jenem gemäß Figur 8 dadurch, daß beliebige elektrisch leitfähige Verbindungen zwischen den aus unterschiedlichem Widerstandsmaterial bestehenden beliebig geformten Widerständen angebracht werden. Bei den Verbindungen kann es sich zum Beispiel um Bondverbindungen B handeln. Die Abstimmung erfolgt durch Anbringen oder Entfernen von Bondverbindungen oder alternativ nach dem Verfahren wie in Bild 8 beschrieben.

In dem in Figur 10 gezeigten Ausführungsbeispiel werden die Widerstandsanordnungen RM für die 3 Kanäle durch die Widerstände R1 bis R3 ausgebildet.

Die Abstimmung erfolgt dadurch, daß elektrisch leitfähige Verbindungen, zum Beispiel Verbindungen B mit einer im Vergleich zur Widerstandsanordnung RM hohen elektrischen Leitfähigkeit angebracht werden.

In Figur 11 ist ein weiteres Ausführungsbeispiel dargestellt, bei dem die Kontaktmatrix für Kanal 1 Kontaktfelder K1 bis K12 umfaßt. Zwischen den Kontaktfeldern K6 und K11 befinden sich elektrisch leitende Verbindungen R1 bis R6, die im Bild als gekrümmte Linien dargestellt sind. Durch zusätzliche elektrische Verbindungen, die als Bondverbindungen B ausgebildet sind, wird der Gesamtwiderstand der Kontaktmatrix abgeglichen.

Figur 12a zeigt ein Ausführungsbeispiel, bei dem die Widerstände der Widerstandsanordnung RM auf der Bauelementezeile abgeordnet sind, so daß die Abstimmung der Widerstandsordnung RM auf der Bauelementezeile erfolgt.

Das zuvor beschriebene Verfahren zum Abstimmen der Halbleiterlaser L1 bis Ln soll nun anhand der Figur 12b nochmals kurz erläutert werden. So wird zunächst eine bestimmte Heizleistung $P \geq O$ mittels der Widerstandseinrichtung RM1 bis RMn oder alternativ über die Spannungsquelle $U_0$ individuell für jeden Halbleiterlaser L1 bis Ln eingestellt. Anschließend erfolgt eine Wellenlängenmessung für jeden Halbleiterlaser L1 bis Ln. Anhand des funktionellen Zusammenhangs λ (P) wird dann die dem entsprechenden Halbleiterlaser L1-Ln zugeordnete Widerstandsanordnung abgeglichen. Je nach gewähltem Verfahren werden diese Schritte mehrmals ausgeführt, bis schließlich die gewünschte charakteristische Wellenlänge für jeden Halbleiterlaser L1-Ln erreicht ist.

An dem vorgenannten Ausführungsbeispiel wird deutlich, daß es eine Vielzahl von Möglichkeiten gibt, mit Hilfe der erfindungsgemäß ausgebildeten Widerstandsanordnung RM1-RMn die Heizleistung Pq der einzelnen Widerstandsheizungen H1-Hn auf einfache Weise individuell einzustellen, ohne auf mehrere Spannungsquellen $U_0$ zurückgreifen zu müssen. Insbesondere lassen sich die einzelnen Widerstände R1-Rn bzw. RI-RV usw. der Widerstandsanordnungen RM1-RMn jederzeit, also auch nachträglich, nach Inbetriebnahme der Bauelemente-Anordnung verändern. So ist es beispielsweise denkbar, durch Zeit- und Temperaturmessungen auf der Grundlage von Erfahrungswerten die Wellenlänge beziehungsweise die Heizleistung Pq zu verändern, um beispielsweise Alterungseffekte zu kompensieren.

Darüber hinaus ist die vorliegende Erfindung nicht nur auf die beschriebenen Halbleiterlaser L1-Ln anwendbar, sondern allgemein auf optoelektronische Bauelemente, wie optische Verstärker, Filter, Wellenlängenmultiplexer oder Wellenleiter.

Bei den vorgenannten Ausführungsbeispielen wurde als Energieversogungseinrichtung jeweils eine Spannungsquelle $U_0$ verwendet. Selbstverständlich ist es ebenso möglich, eine Stromquelle I einzusetzen, wie es in Figur 13 dargestellt ist, wobei die Widerstandsanordnung RM1-RMn und die Widerstandsheizungen H1-Hn parallel und nicht in Reihe zueinander liegen.

**Aufstellung der verwendeten Bezugszeichen**

| | |
|---|---|
| L1-Ln | Halbleiterlaser |
| $U_0$ | Spannungsquelle |
| I | Stromquelle |
| H | Widerstandsheizung |
| H1-Hn | Widerstandsheizungen der Halbleiterlaser |
| Hq | Widerstandsheizung eines Kanals q |
| Rq | Widerstand der Widerstandsheizung eines Kanals q |
| $R_{q,i,j}$-$R_{q,k,l}$ | Widerstände der Widerstandsheizungen |
| $R_{v1}$-$R_{v3}$ | Vorwiderstände |
| $R_{L1}$-$R_{L3}$ | Leitungswiderstände von Rq |
| LQ | elektrische Verbindungen der Spannungsquelle $U_0$ mit den Kontaktfeldern der einzelnen Kanäle q |
| Pq | Heizleistung eines Kanals q |
| RM | Widerstandsanordnung |
| RM1-RMn | Widerstandsanordnungen der optoelektronischen Bauelemente |
| R1-Rn | Widerstände der Widerstandsanordnungen |
| RI- RXVII | Widerstände der Widerstandsanordnung, aus unterschiedlichem Widerstandsmaterial |
| A1-An | Verbindungen und leitfähigen Bereiche, die im eigentlichen Sinne keine Widerstände sind |
| B | Bondverbindungen |
| K1-Kn | Kontaktfelder (Bondpads) |
| $K_{L1}$-$K_{L3}$ | Kontaktfelder |
| $K_{q,i,j^-q,k,l}$ | Kontaktfelder |
| $K_{q,t,u^-q,v,w}$ | Kontaktfelder |
| x, y | Ortskoordinate |
| Weg | S1;S2 |

## Patentansprüche

1. Verfahren zur Wellenlängenabstimmung einer optoelektronischen Bauelemente-Anordnung mit zumindest zwei optoelektronischen Bauelementen, bei dem die Einstellung der charakteristischen Wellenlänge für jedes optoelektronische Bauelement unter Anwendung des Prinzips der thermischen Einstellung der charakteristischen Wellenlänge über die jeweilige Widerstandsheizung erfolgt, und bei dem die Wellenlängenabweichung anhand des Vergleichs der gemessenen Wellenlänge mit der gewünschten charakteristischen Wellenlänge ermittelt wird, **dadurch gekennzeichnet, daß** die zur Einstellung der charakteristischen Wellenlänge des optoelektronischen Bauelements notwendige thermische Änderung der Widerstandsheizung (H) durch gezielte Änderung des Widerstandswertes einer der Widerstandsheizung (H) vorgeschalteten Widerstandsanordnung (RM) erfolgt.

2. Verfahren nach Anspruch 1, **dadurch gekennzeichnet daß** die Änderung des Widerstandswertes der Widerstandsanordnung (RM) durch schaltungstechnische Maßnahmen erfolgt.

3. Verfahren nach Anspruch 1, **dadurch gekennzeichnet, daß** die Änderung des Widerstandswertes der Widerstandsanordnung (RM) durch Materialveränderung, vorzugsweise Materialab- oder Materialauftrag erfolgt.

4. Verfahren nach Anspruch 1, **dadurch gekennzeichnet, daß** die Änderung des Widerstandswertes der Widerstandsanordnung (RM) durch Laserablation erfolgt.

5. Verfahren nach Anspruch 1, **dadurch gekennzeichnet, daß** die Änderung des Widerstandswertes der Widerstandsanordnung (RM) durch thermische Behandlung erfolgt.

6. Verfahren nach Anspruch 1, **dadurch gekennzeichnet, daß** die Änderung des Widerstandswertes der Widerstandsanordnung (RM) durch chemische bzw. elektrochemische Behandlung erfolgt.

7. Verfahren nach Anspruch 1, **dadurch gekennzeichnet, daß** die Änderung des Widerstandswertes der Widerstandsanordnung (RM) durch Teilchenimplantation, elektromagnetische Strahlung bzw. Teilchenstrahlung erfolgt.

8. Verfahren nach Anspruch 1, **dadurch gekennzeichnet, daß** die Änderung des Widerstandswertes der Widerstandsanordnung (RM) durch ein elektrisches Signal erfolgt.

9. Verfahren nach einem der vorhergehenden Ansprüche **dadurch gekennzeichnet, daß** es in regelmäßigen Zeitabständen durchgeführt wird.

10. Anordnung zur Wellenlängenabstimmung einer optoelektronischen Bauelemente-Anordnung mit zumindest zwei optoelektronischen Bauelementen und zumindest einer jeweils einem Bauelement zugeordneten Widerstandsheizung (H) zur Einstellung der charakteristischen Wellenlänge des optoelektronischen Bauelements, **dadurch gekennzeichnet, daß** jeder Widerstandsheizung (H1-Hn) eine separate, mit der gemeinsamen Spannungs- oder Stromquelle ($U_o$/I) verbundene, in ihrem Gesamtwiderstand veränderbare Widerstandsanordnung (RM1-RMn) vorgeschaltet ist.

11. Anordnung nach Anspruch 10, **dadurch gekennzeichnet, daß** die Widerstandsanordnungen (RM1-BMn) aus einzelnen zu einem Widerstandsarray angeordneten Widerständen bestehen.

12. Anordnung nach Anspruch 10 und 11, **dadurch gekennzeichnet, daß** die Widerstände der Widerstandsanordnungen (RM1-RMn) zwischen in Reihen liegenden Kontaktfelder (K1-Kn) geschaltet sind, wobei sie einem festen Ordnungsprinzip in Bezug auf ihre Widerstandswerte in der jeweiligen Reihe unterliegen, und **daß** die konkrete Ausbildung des Gesamtwiderstandes jeder einzelnen Widerstandsanordnung (RM1-RMn) über die Kontaktfelder (K1-Kn), vorzugsweise mittels Bondverbindungen (B), erfolgt.

13. Bauelemente-Anordnung nach Anspruch 12, **dadurch gekennzeichnet, daß** die Kontaktfelder (K1-Kn) zur Anbringung 'elektrischer Leitungen, vorzugsweise als Kontaktfelder (K1-Kn) mit Bondpads ausgebildet sind.

14. Bauelemente-Anordnung nach einem der vorhergehenden Ansprüche, **dadurch gekennzeichnet, daß** die Widerstände der Widerstandsanordnungen (RM1-RMn) alternativ aus Metall, Nichtmetall, Halbleiter, Flüssigkeit, Gel, Keramik, Oxyd, Metall-Matrix-Verbindung, Flüssigkristallen und Polymeren bestehen.

15. Bauelemente-Anordnung nach einem der vorhergehenden Ansprüche, **dadurch gekennzeichnet, daß** die optoelektronischen Bauelemente auf einem ersten Körper und zumindest Teile der Widerstandsanordnungen (RM1-RMn) auf zumindest einem weiteren Körper angeordnet sind.

16. Bauelemente-Anordnung nach Anspruch 15, **dadurch gekennzeichnet, daß** der erste Körper vorzugsweise aus Halbleitermaterialien besteht, und **daß** der zweite Körper ein Isolator ist.

17. Bauelemente-Anordnung nach einem der vorhergehenden Ansprüche, **dadurch gekennzeichnet, daß** das optoelektronische Bauelement ein Halbleiterlaser, ein optischer Verstärker, ein Filter, ein Wellenlängenmultiplexer oder ein Wellenleiter ist.

## Claims

1. Process for the wavelength tuning of an optoelectronic component arrangement with at least two optoelectronic components, wherein the characteristic wavelength is set for each optoelectronic component using the principle of the thermal setting of the characteristic wavelength by means of the respective resistance heater, the wavelength deviation being determined on the basis of a comparison of the measured wavelength with the desired characteristic wavelength, **characterized in that** the thermal change of the resistance heater (H) required for setting the characteristic wavelength of the optoelectronic component is accomplished by selectively changing the resistance value of a resistor arrangement (RM) connected upstream of the resistance heater (H).

2. Process according to claim 1, **characterized in that** the change of the resistance value of the resistor arrangement (RM) is accomplished by circuitry-related measures.

3. Process according to claim 1, **characterized in that** the change of the resistance value of the resistor arrangement (RM) is accomplished by a change of material, preferably the removal or application of material.

4. Process according to claim 1, **characterized in that** the change of the resistance value of the resistor arrangement (RM) is accomplished by laser ablasion.

5. Process according to claim 1, **characterized in that** the change of the resistance value of the resistor arrangement (RM) is accomplished by heat treatment.

6. Process according to claim 1, **characterized in that** the change of the resistance value of the resistor arrangement (RM) is accomplished by chemical or electrochemical treatment.

7. Process according to claim 1, **characterized in that** the change of the resistance value of the resistor arrangement (RM) is accomplished by particle implantation, electromagnetic radiation or particle radiation.

8. Process according to claim 1, **characterized in that** the change of the resistance value of the resistor arrangement (RM) is accomplished by an electrical signal.

9. Process according to any one of the preceding claims, **characterized in that** said process is carried out at regular intervals.

10. Arrangement for the wavelength tuning of an optoelectronic component arrangement with at least two optoelectronic components and at least one resistance heater (H) associated with each component for setting the characteristic wavelength of the optoelectronic component, **characterized in that** connected upstream of each resistance heater (H1-Hn) is a separate resistor arrangement (RM1-RMn), said resistor arrangement (RM1-RMn) being connected to the common voltage or current source ($U_0$/I) and being variable in its total resistance.

11. Arrangement according to claim 10, **characterized in that** the resistor arrangements (RM1-RMn) consist of individual resistors disposed in an array of resistors.

12. Arrangement according to claims 10 and 11, **characterized in that** the resistors of the resistor arrangements (RM1-RMn) are connected between contact fields (K1-Kn) situated in rows, said resistors being arranged in a fixed order with regard to their resistance values in the respective row, the specific total resistance of each individual resistor arrangement (RM1-RMn) being formed by way of the contact fields (K1-Kn), preferably by means of bond connections (B).

13. Component arrangement according to claim 12, **characterized in that,** for the attachment of electric leads, the contact fields (K1-Kn) are preferably in the form of contact fields (K1-Kn) with bond pads.

14. Component arrangement according to any one of the preceding claims, **characterized in that** the resistors of the resistor arrangements (RM1-RMn) consist alternatively of metal, non-metal, semiconductor material, liquid, gel, ceramic, oxide, metal-matrix compound, liquid crystals and polymers.

15. Component arrangement according to any one of the preceding claims, **characterized in that** the optoelectronic components are disposed on a first body and at least parts of the resistor arrangements (RM1-RMn) are disposed on at least one further body.

16. Component arrangement according to claim 15, **characterized in that** the first body consists preferably of semiconductor materials, the second body being an insulator.

17. Component arrangement according to any one of the preceding claims, **characterized in that** the optoelectronic component is a solid-state laser, an optical amplifier, a filter, a wavelength multiplexer or a waveguide.

## Revendications

1. Procédé d'ajustement de la longueur d'onde d'un dispositif d'éléments optoélectroniques comprenant au moins deux éléments optoélectroniques par lequel le réglage de la longueur d'onde caractéristique de chaque élément optoélectronique s'effectue selon le principe du réglage thermique de la longueur d'onde caractéristique au moyen du chauffage par résistance respectif, et par lequel l'écart de longueur d'onde est déterminé en comparant la longueur d'onde mesurée à la longueur d'onde caractéristique voulue, **caractérisé en ce que** la modification thermique du chauffage par résistance (H) nécessaire au réglage de la longueur d'onde caractéristique de l'élément optoélectronique est effectuée par une modification ciblée de la valeur de résistance de l'un des dispositifs de résistances placés en amont du chauffage par résistance (H).

2. Procédé selon la revendication 1, **caractérisé en ce que** la modification de la valeur de résistance du dispositif de résistances (RM) est effectuée par des mesures de circuiterie.

3. Procédé selon la revendication 1, **caractérisé en ce que** la modification de la valeur de résistance du dispositif de résistances (RM) est effectuée par modification des matériaux, de préférence par enlèvement ou ajout de matériaux.

4. Procédé selon la revendication 1, **caractérisé en ce que** la modification de la valeur de résistance du dispositif de résistances (RM) est effectuée par ablation au laser.

5. Procédé selon la revendication 1, **caractérisé en ce que** la modification de la valeur de résistance du dispositif de résistances (RM) est effectuée par traitement thermique.

6. Procédé selon la revendication 1, **caractérisé en ce que** la modification de la valeur de résistance du dispositif de résistances (RM) est effectuée par traitement chimique ou électrochimique.

7. Procédé selon la revendication 1, **caractérisé en ce que** la modification de la valeur de résistance du dispositif de résistances (RM) est effectuée par implantation de particules, radiation électromagnétique ou particulaires.

8. Procédé selon la revendication 1, **caractérisé en ce que** la modification de la valeur de résistance du dispositif de résistances (RM) est effectuée au moyen d'un signal électrique.

9. Procédé selon l'une des revendications ci-dessus, **caractérisé en ce qu'**il est effectué à intervalles réguliers.

10. Dispositif d'ajustement de la longueur d'onde d'un dispositif d'éléments optoélectroniques comprenant au moins deux éléments optoélectroniques et au moins un chauffage par résistance (H) affecté à chaque élément pour le réglage de la longueur d'onde caractéristique de l'élément optoélectronique, **caractérisé en ce qu'** un dispositif de résistances (RM1-RMn) séparé, connecté à la source commune de tension ou de courant ($U_0$/I) et modifiable au niveau de sa résistance totale, est placé en amont de chaque chauffage par résistance (H1-Hn).

11. Dispositif selon la revendication 10, **caractérisé en ce que** les dispositifs de résistances (RM1-RMn) sont constitués de plusieurs résistances disposées en une matrice de résistances.

12. Dispositif selon les revendications 10 et 11, **caractérisé en ce que** les résistances des dispositifs de résistances (RM1-RMn) sont placées entre des champs de contact (K1-Kn) disposés en rangées, selon un ordre établi en fonction de leur valeur de résistance dans les différentes rangées, et que la résistance totale de chaque dispositif de résistances (RM1-RMn) se forme concrètement par les champs de contact (K1-Kn), de préférence par *bonding* (B).

**13.** Dispositif d'éléments selon la revendication 12, **caractérisé en ce que** les champs de contact (K1-Kn) pour la fixation de circuits électriques sont configurés de préférence en champs de contact (K1-Kn) avec des *bond pads*.

**14.** Dispositif d'éléments selon l'une des revendications ci-dessus, **caractérisé en ce que** les résistances des dispositifs de résistances (RM1-RMn) sont constituées de métal, non-métal, matériel semiconducteur, liquide, gel, céramique, oxyde, composé métal-matrice, cristaux liquides ou polymères.

**15.** Dispositif d'éléments selon l'une des revendications ci-dessus, **caractérisé en ce que** les éléments optoélectroniques sont disposés sur un premier corps et qu'au moins une partie des dispositifs de résistances (RM1-RMn) sont disposés sur au moins un autre corps.

**16.** Dispositif d'éléments selon la revendication 15, **caractérisé en ce que** le premiers corps est composé de préférence de matériaux semiconducteurs et le deuxième corps est un isolant.

**17.** Dispositif d'éléments selon l'une des revendications ci-dessus, **caractérisé en ce que** l'élément optoélectronique est un laser semiconducteur, un amplificateur optique, un filtre, un multiplexeur en longueur d'onde ou un guide d'onde.

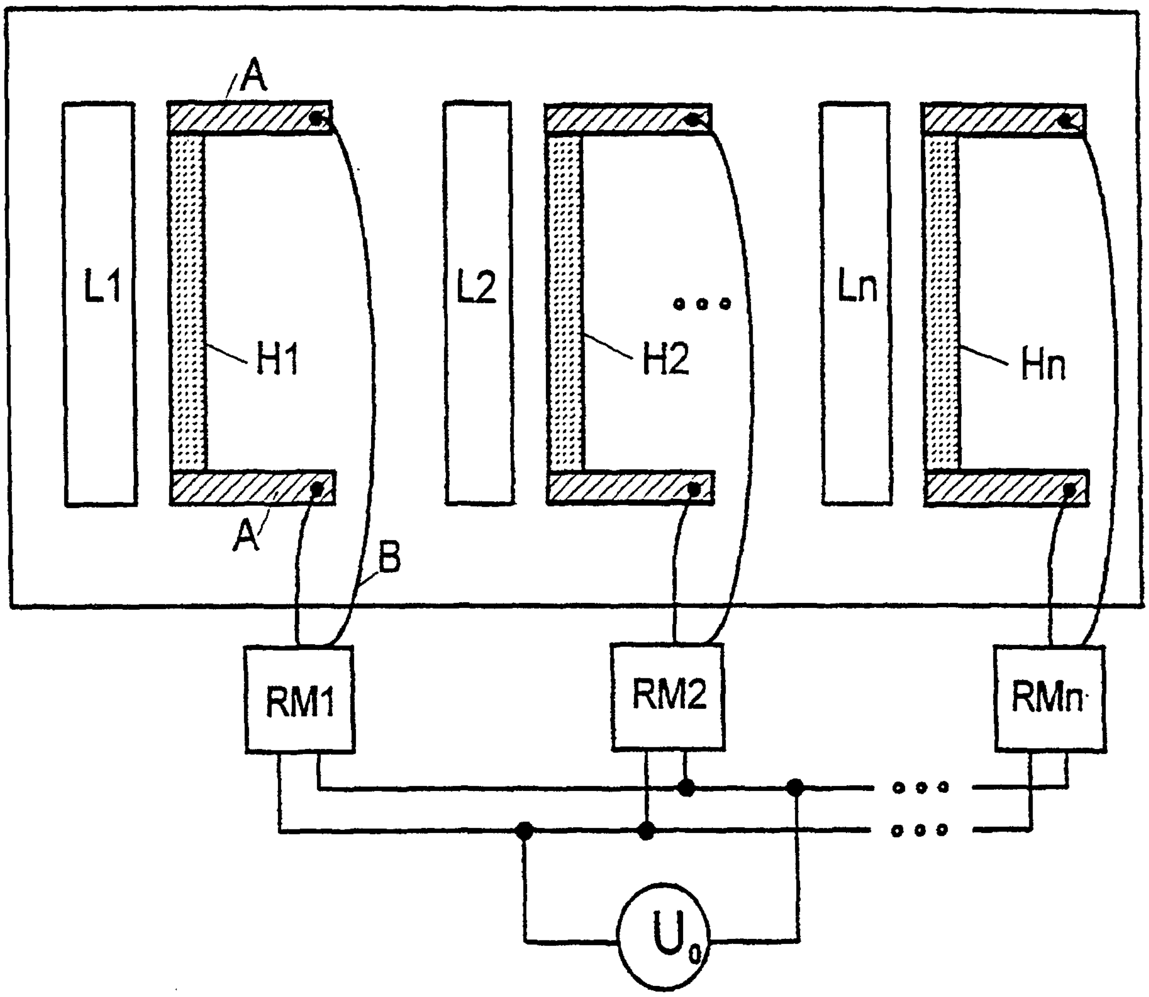


Fig. 1

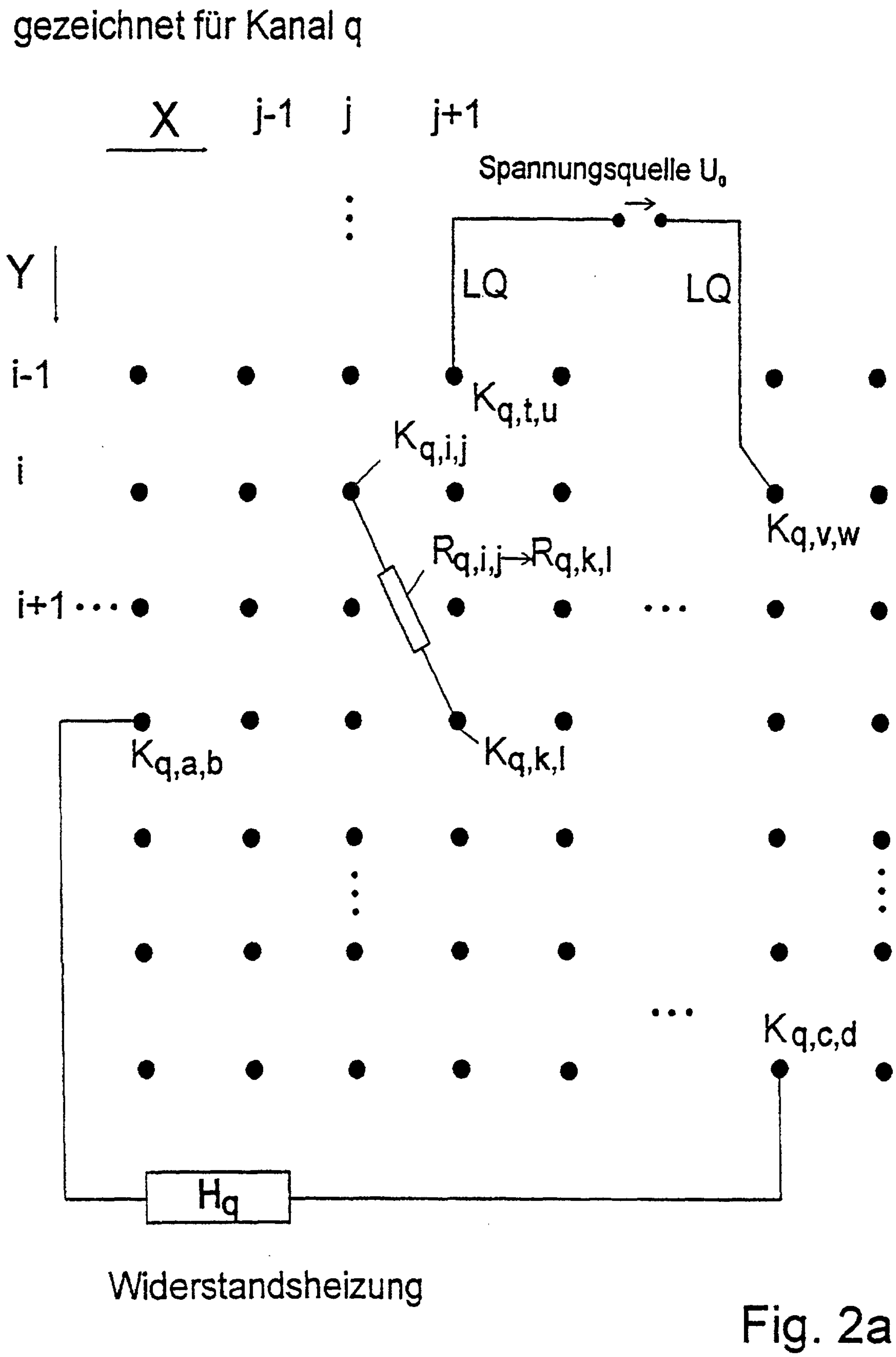

gezeichnet für Kanal q
X
j-1
j
j+1
Spannungsquelle U0
Y
LQ
LQ
i-1
i
i+1
Kq,t,u
Kq,i,j
Kq,v,w
Rq,i,j→Rq,k,l
Kq,a,b
Kq,k,l
Kq,c,d
Hq
Widerstandsheizung


Fig. 2a

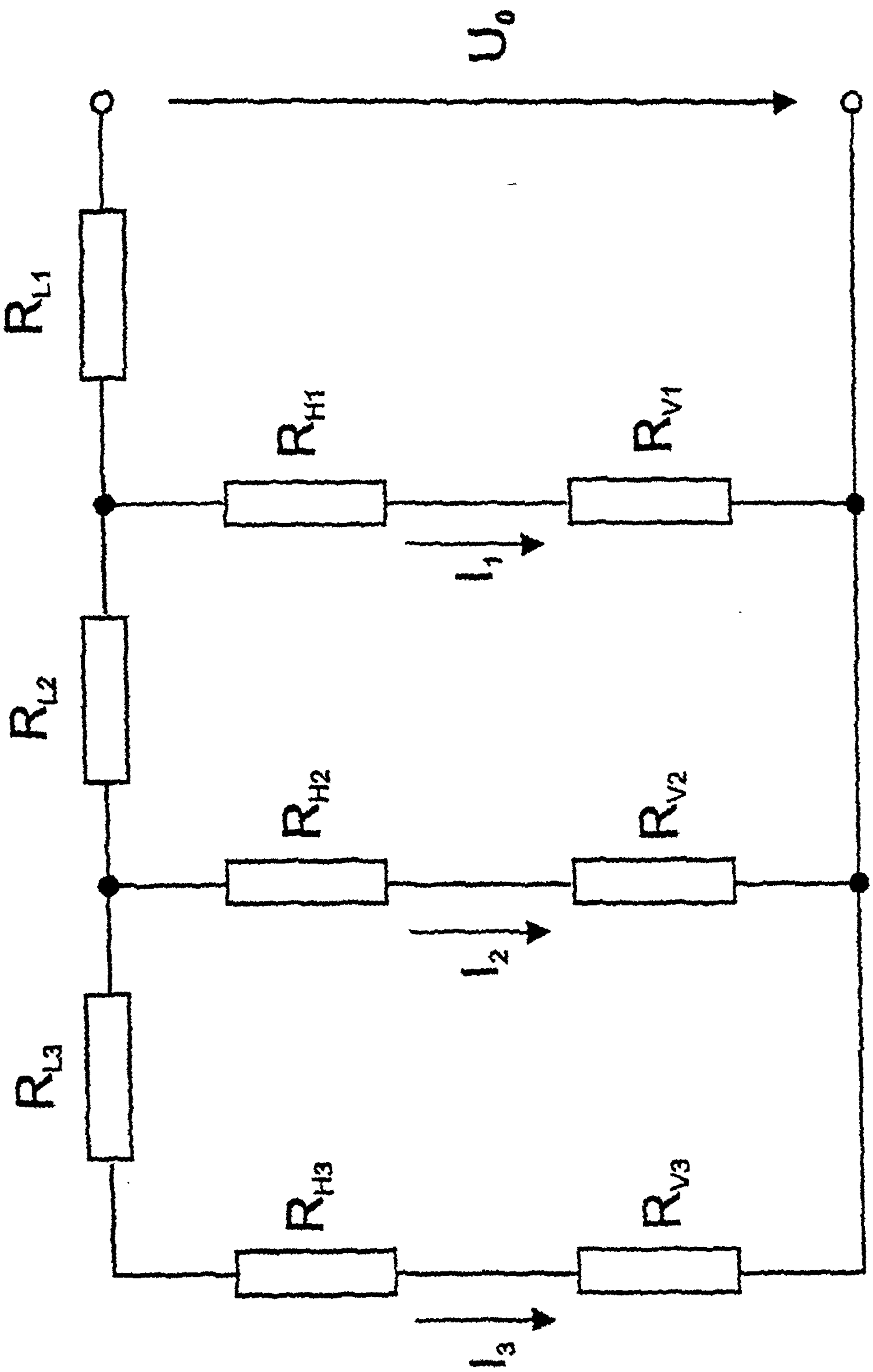


Fig. 2b

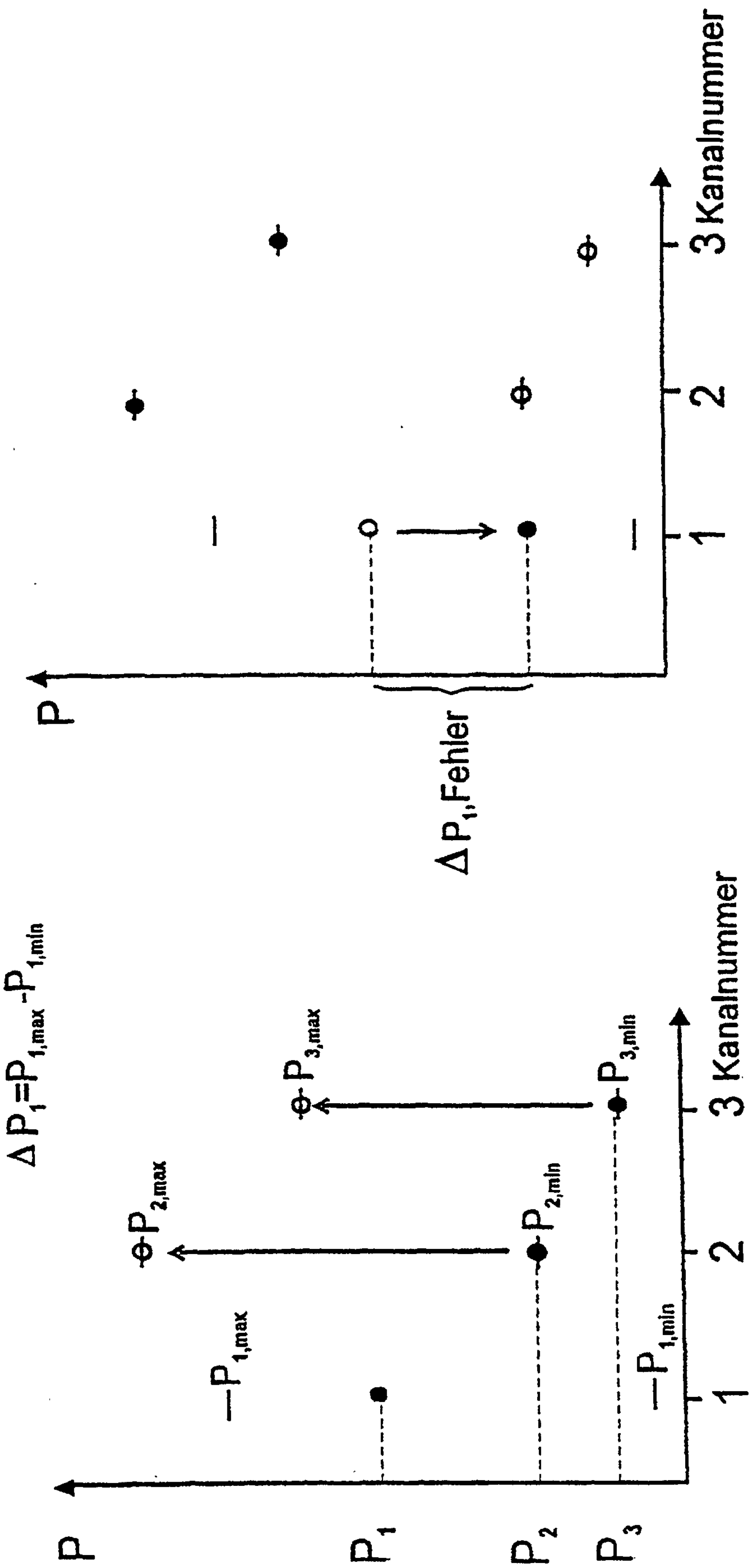

P
P1
P2
P3
P1,max
P1,min
P2,max
P2,min
P3,max
P3,min
ΔP1=P1,max-P1,min
1
2
3 Kanalnummer
ΔP1,Fehler


Fig. 2c

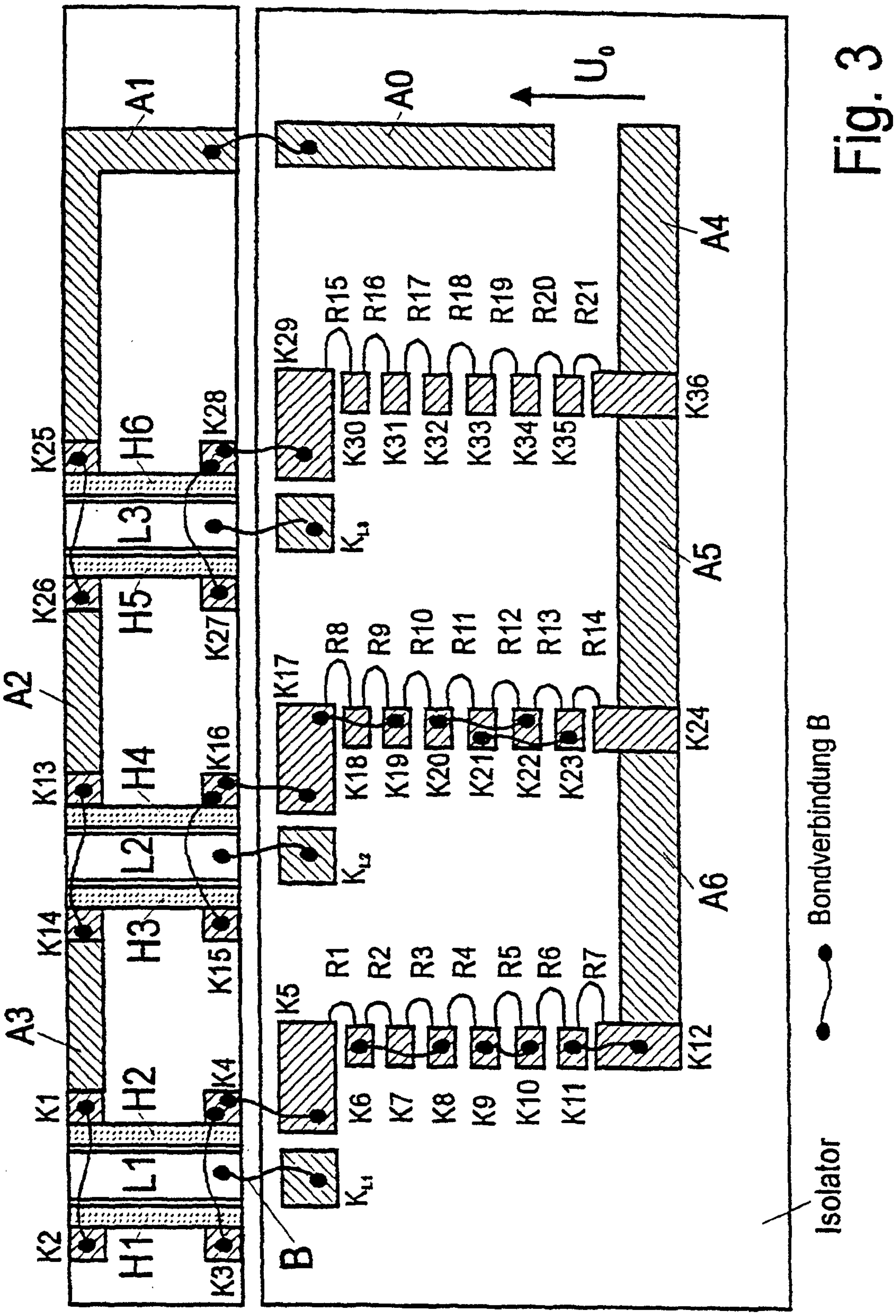
A0
A1
A2
A3
A4
A5
A6
U0
B
H1
H2
H3
H4
H5
H6
L1
L2
L3
K1
K2
K3
K4
K5
K6
K7
K8
K9
K10
K11
K12
K13
K14
K15
K16
K17
K18
K19
K20
K21
K22
K23
K24
K25
K26
K27
K28
K29
K30
K31
K32
K33
K34
K35
K36
KL1
KL2
KL3
R1
R2
R3
R4
R5
R6
R7
R8
R9
R10
R11
R12
R13
R14
R15
R16
R17
R18
R19
R20
R21
Bondverbindung B
Isolator

Fig. 3

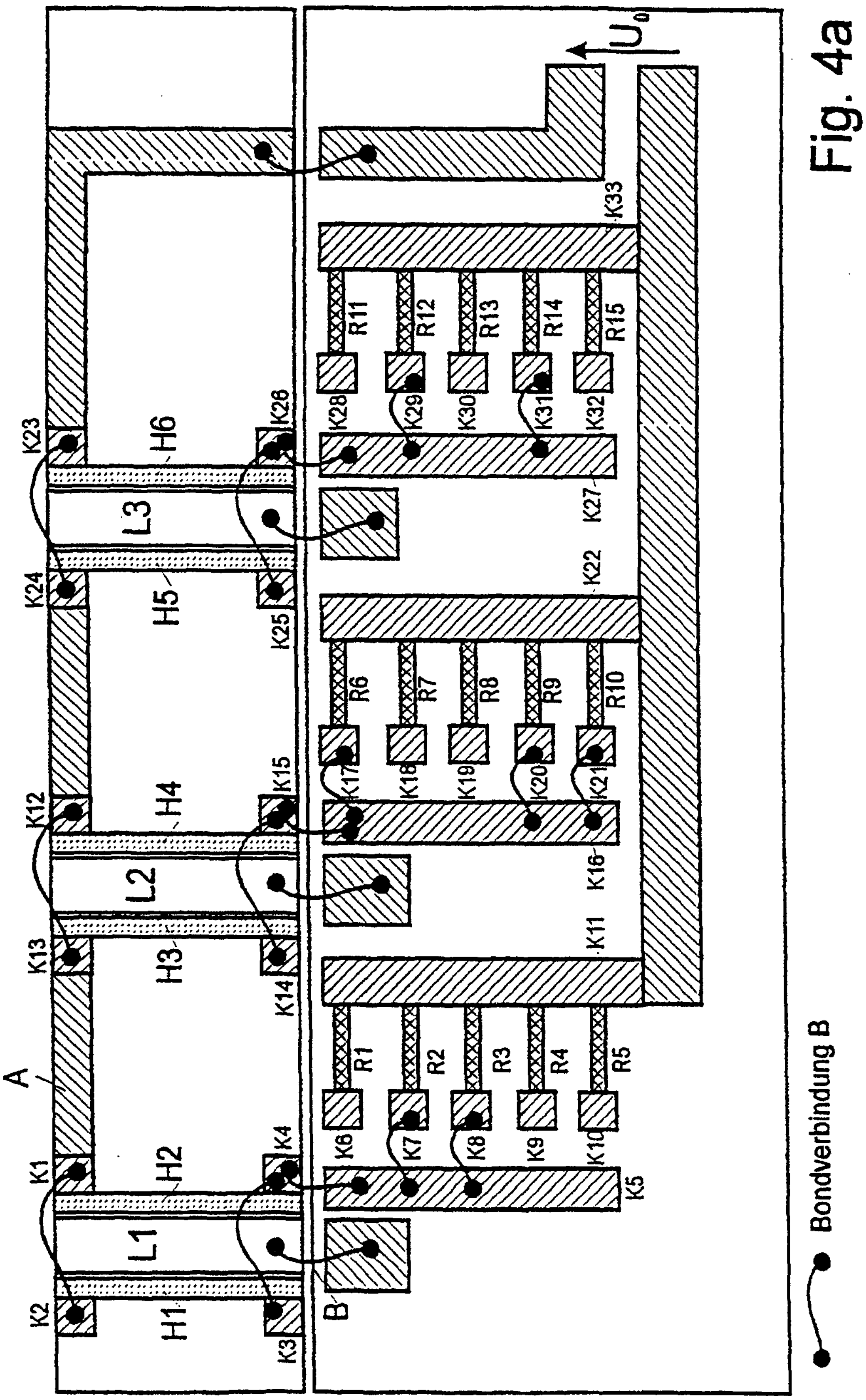
A
B
L1
L2
L3
H1
H2
H3
H4
H5
H6
K1
K2
K3
K4
K5
K6
K7
K8
K9
K10
K11
K12
K13
K14
K15
K16
K17
K18
K19
K20
K21
K22
K23
K24
K25
K26
K27
K28
K29
K30
K31
K32
K33
R1
R2
R3
R4
R5
R6
R7
R8
R9
R10
R11
R12
R13
R14
R15
U0
Bondverbindung B

Fig. 4a

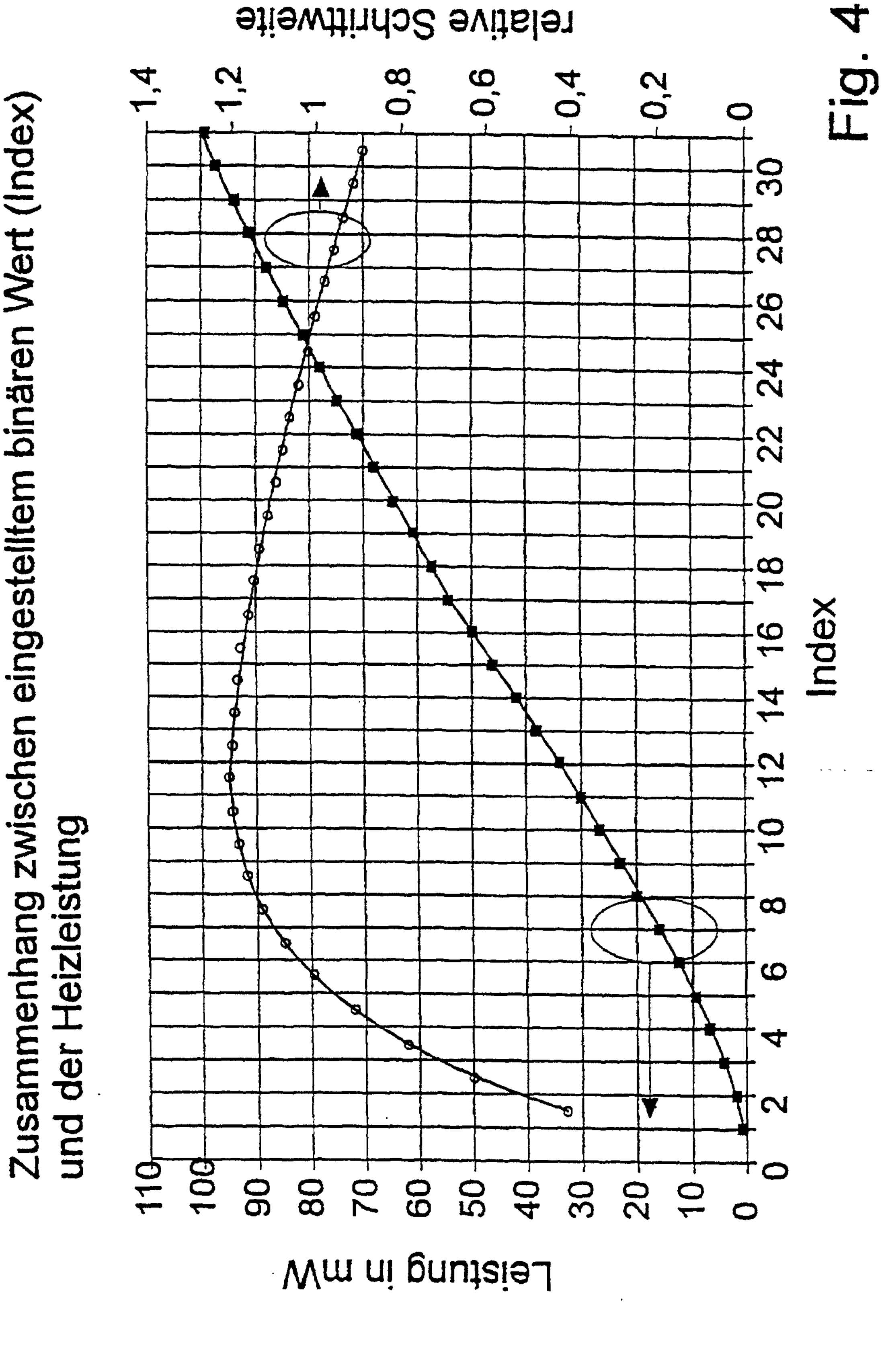
Zusammenhang zwischen eingestelltem binären Wert (Index)
und der Heizleistung
Leistung in mW
0
10
20
30
40
50
60
70
80
90
100
110
relative Schrittweite
0
0,2
0,4
0,6
0,8
1
1,2
1,4
Index
0
2
4
6
8
10
12
14
16
18
20
22
24
26
28
30

Fig. 4b

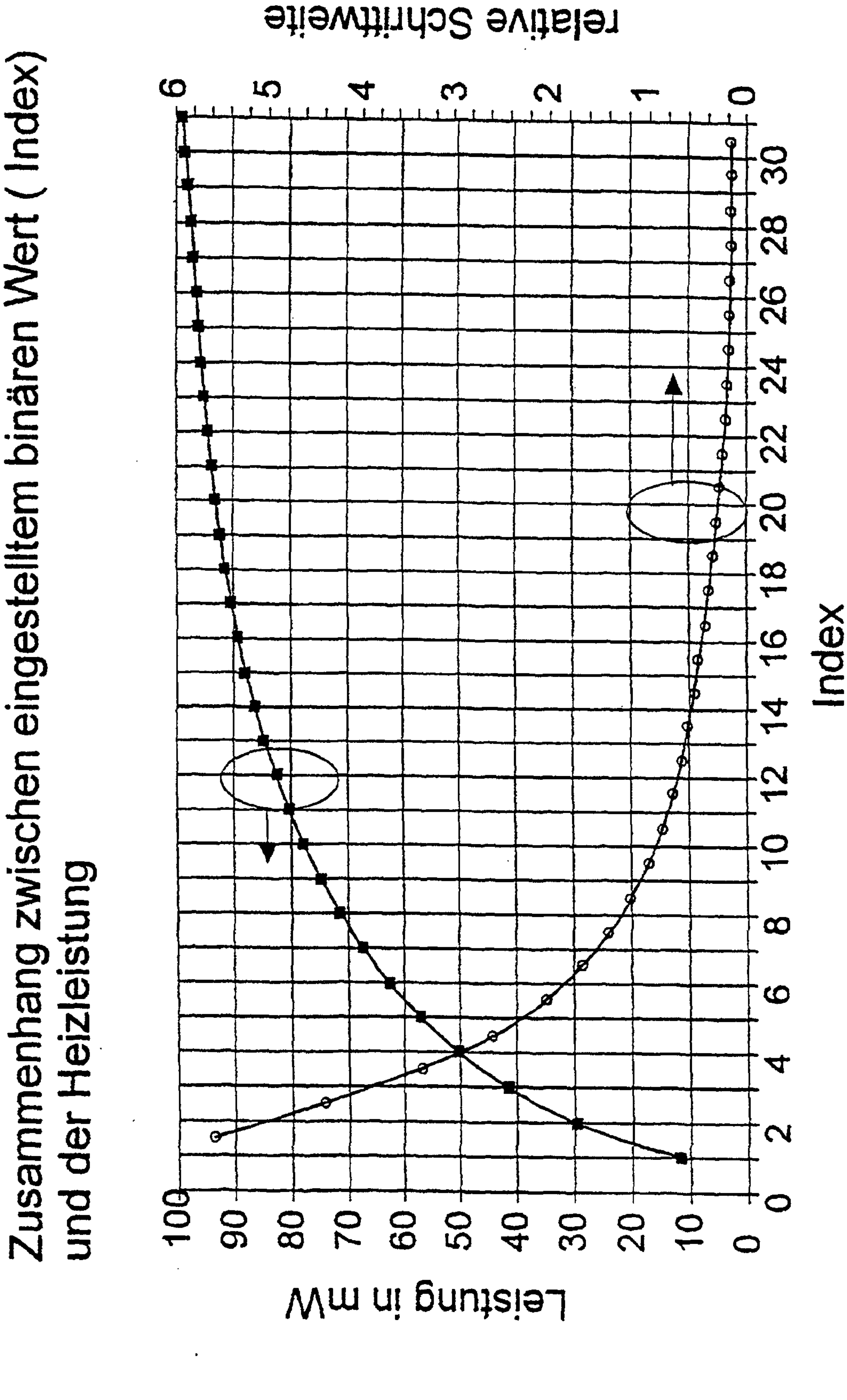
Zusammenhang zwischen eingestelltem binären Wert ( Index)
und der Heizleistung
Leistung in mW
relative Schrittweite
Index
100
90
80
70
60
50
40
30
20
10
0
6
5
4
3
2
1
0
0
2
4
6
8
10
12
14
16
18
20
22
24
26
28
30

Fig. 4c

Zusammenhang zwischen eingestelltem binären Wert (Index) und der Heizleistung

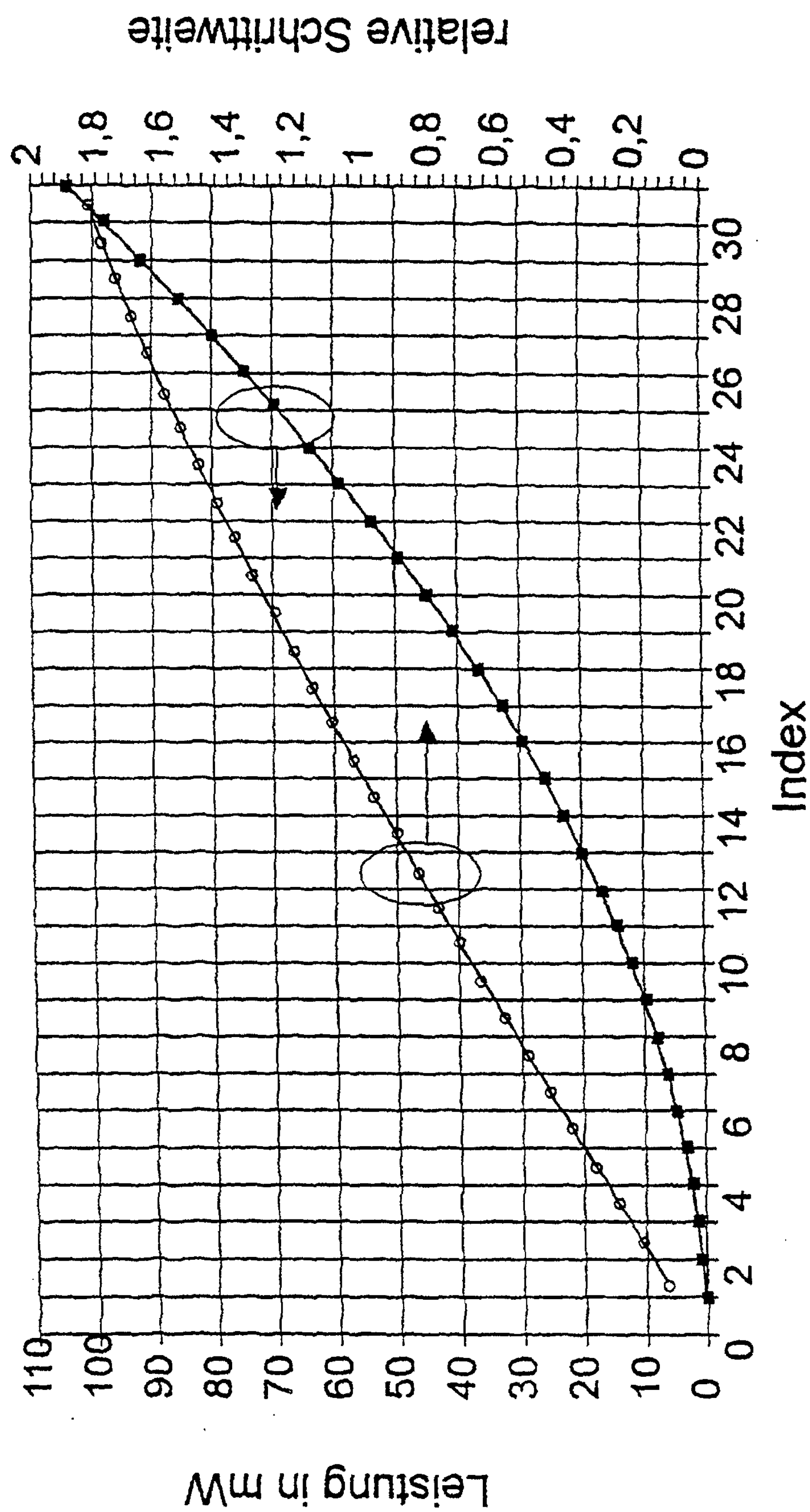


Fig. 4d

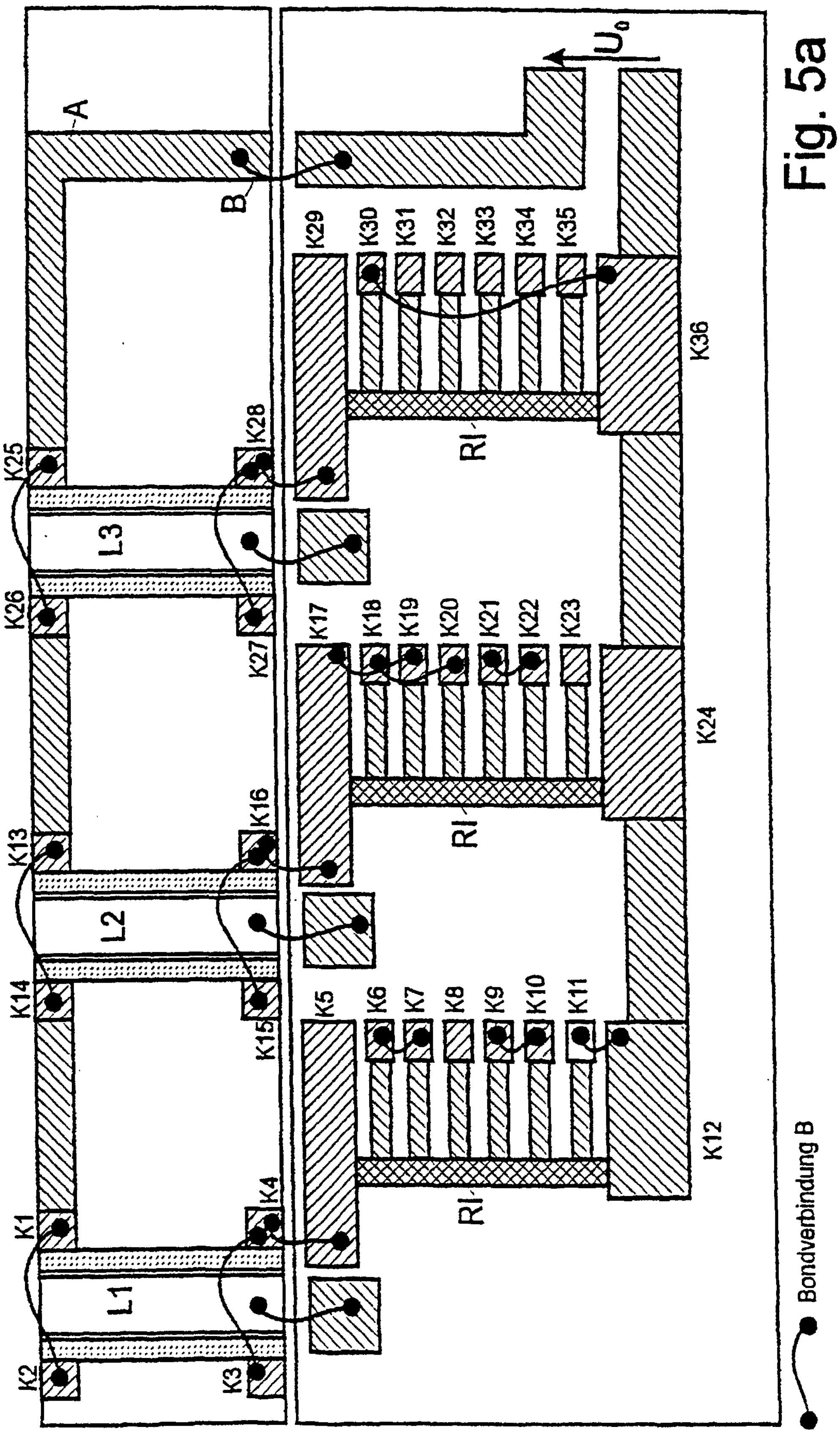


Fig. 5a

Bondverbindung B

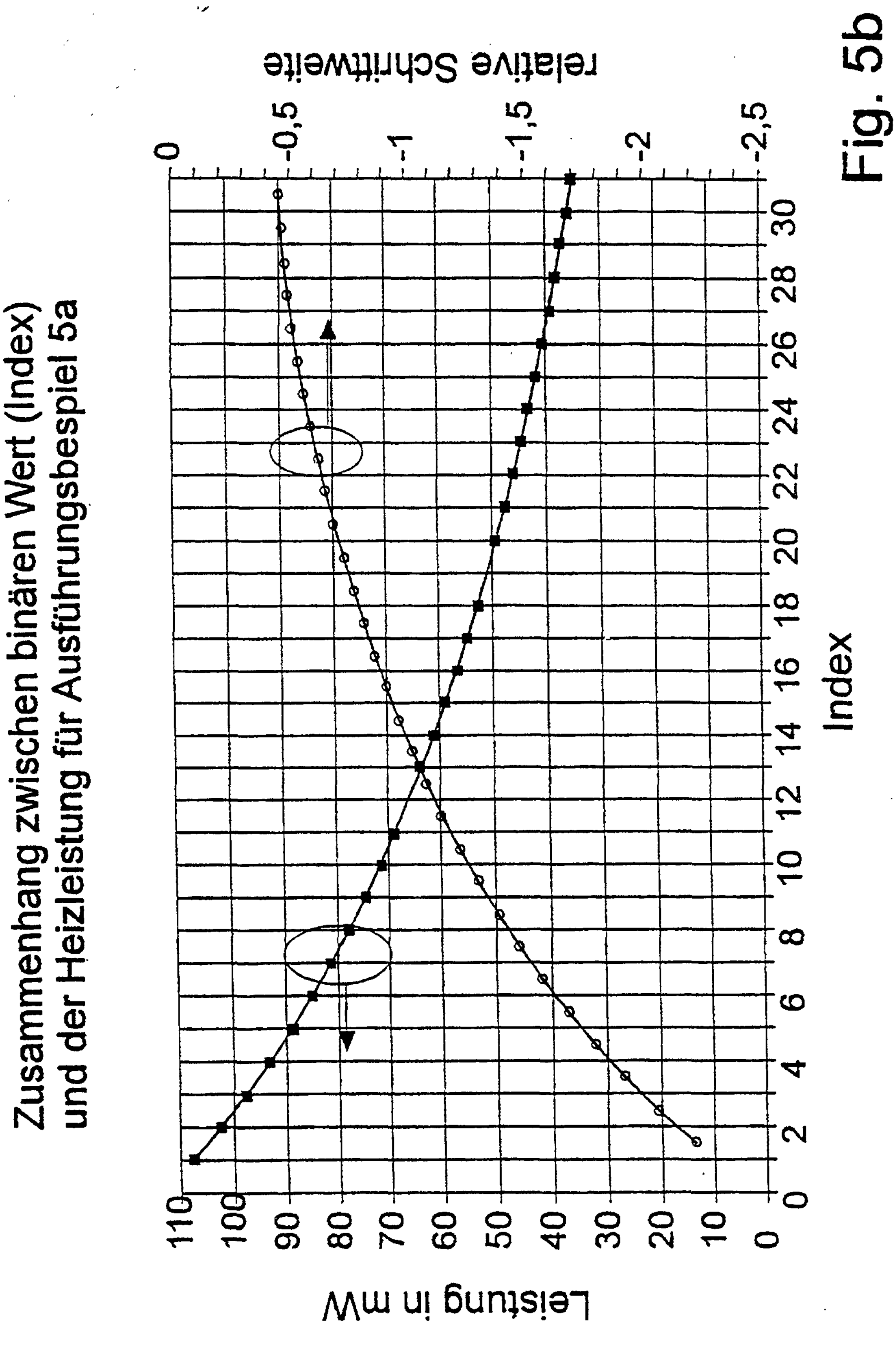
Zusammenhang zwischen binären Wert (Index)
und der Heizleistung für Ausführungsbespiel 5a
relative Schrittweite
0
-0,5
-1
-1,5
-2
-2,5
Leistung in mW
110
100
90
80
70
60
50
40
30
20
10
0
2
4
6
8
10
12
14
16
18
20
22
24
26
28
30
Index

Fig. 5b

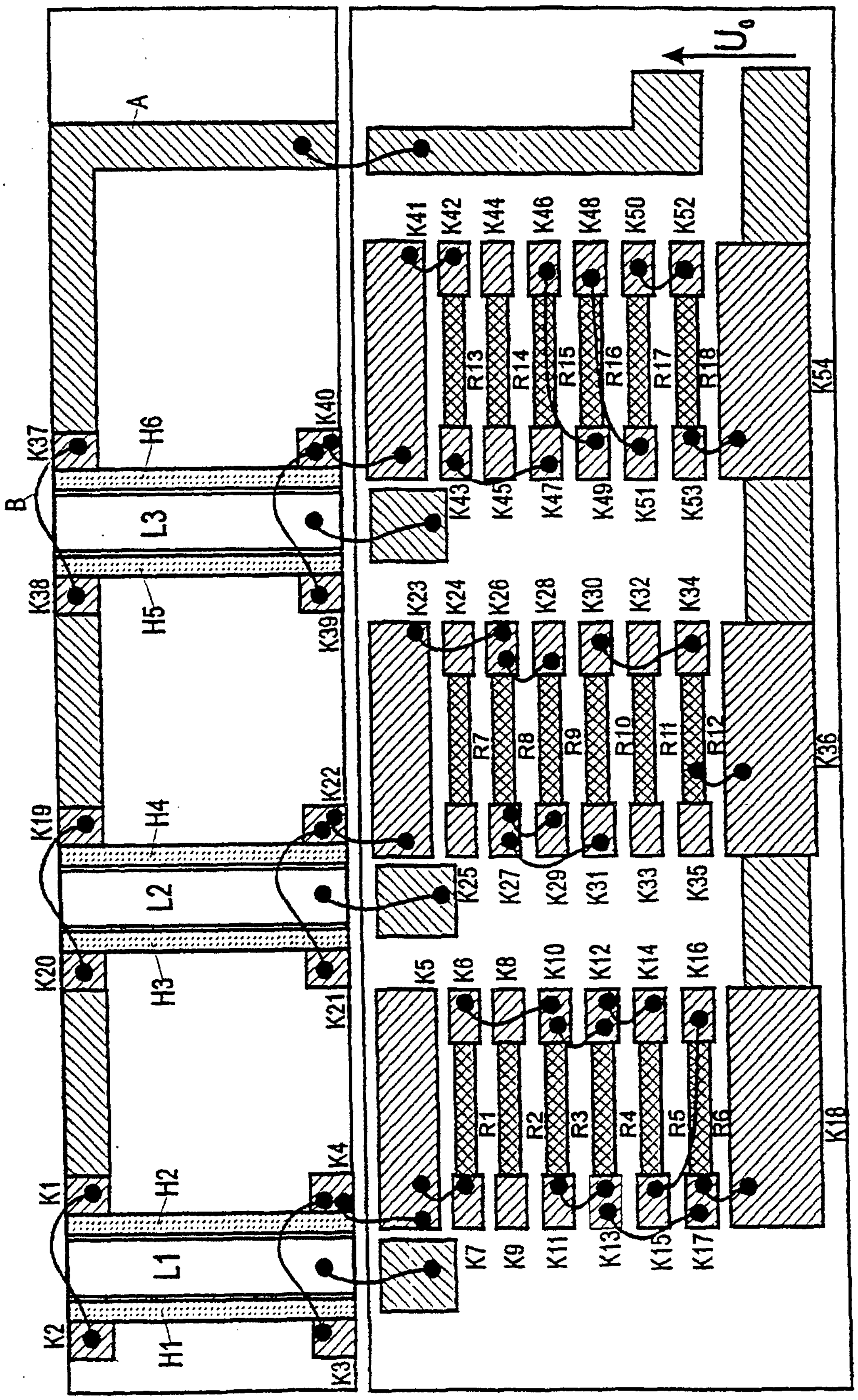
A
B
U0
K1 K2 K3 K4 K5 K6 K7 K8 K9 K10 K11 K12 K13 K14 K15 K16 K17 K18
K19 K20 K21 K22 K23 K24 K25 K26 K27 K28 K29 K30 K31 K32 K33 K34 K35 K36
K37 K38 K39 K40 K41 K42 K43 K44 K45 K46 K47 K48 K49 K50 K51 K52 K53 K54
H1 H2 H3 H4 H5 H6
L1 L2 L3
R1 R2 R3 R4 R5 R6 R7 R8 R9 R10 R11 R12 R13 R14 R15 R16 R17 R18
Bondverbindung B

Fig. 6

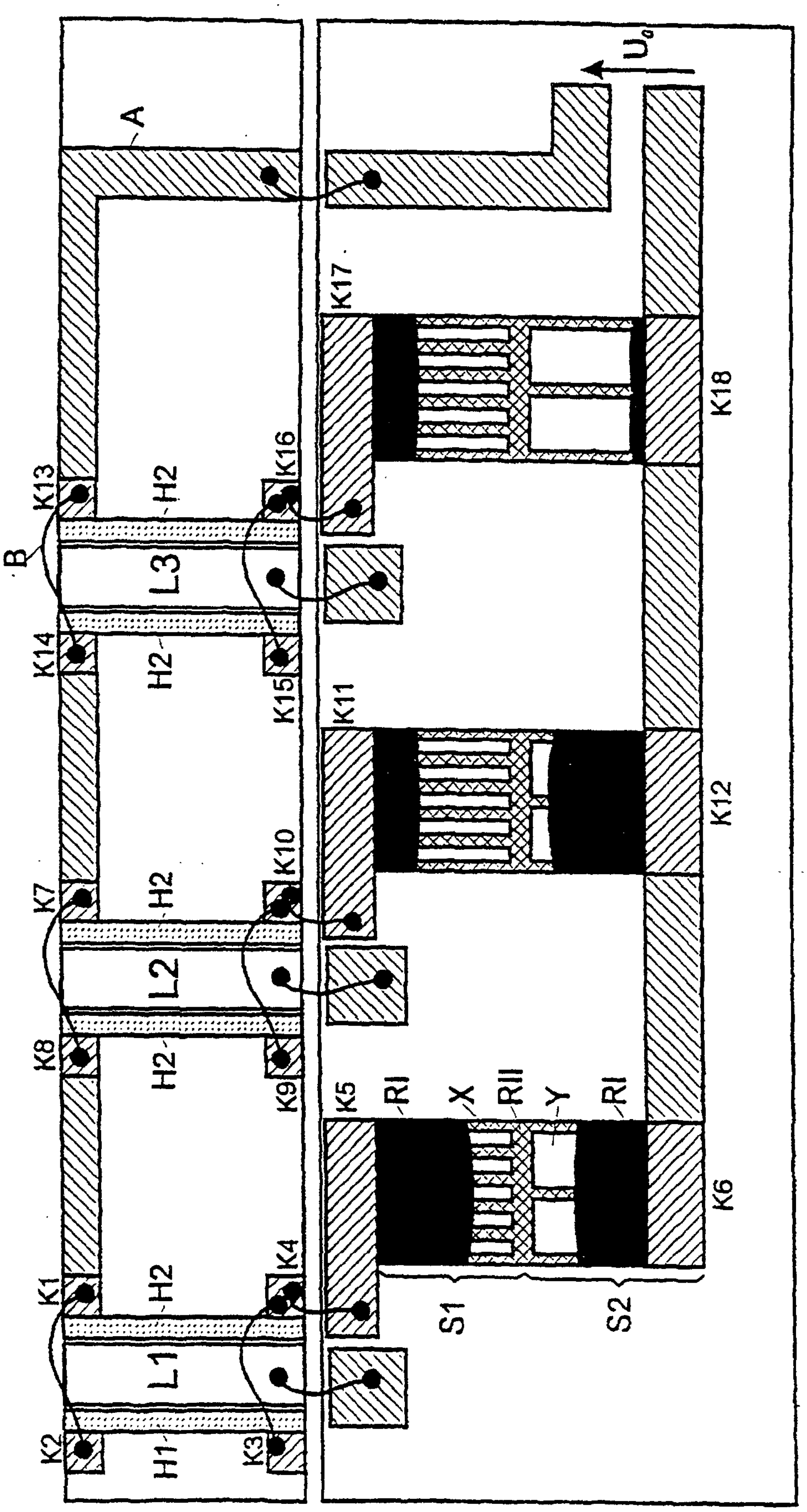
A
B
K1
K2
K3
K4
K5
K6
K7
K8
K9
K10
K11
K12
K13
K14
K15
K16
K17
K18
L1
L2
L3
H1
H2
RI
X
RII
Y
S1
S2
Ua

Fig. 7

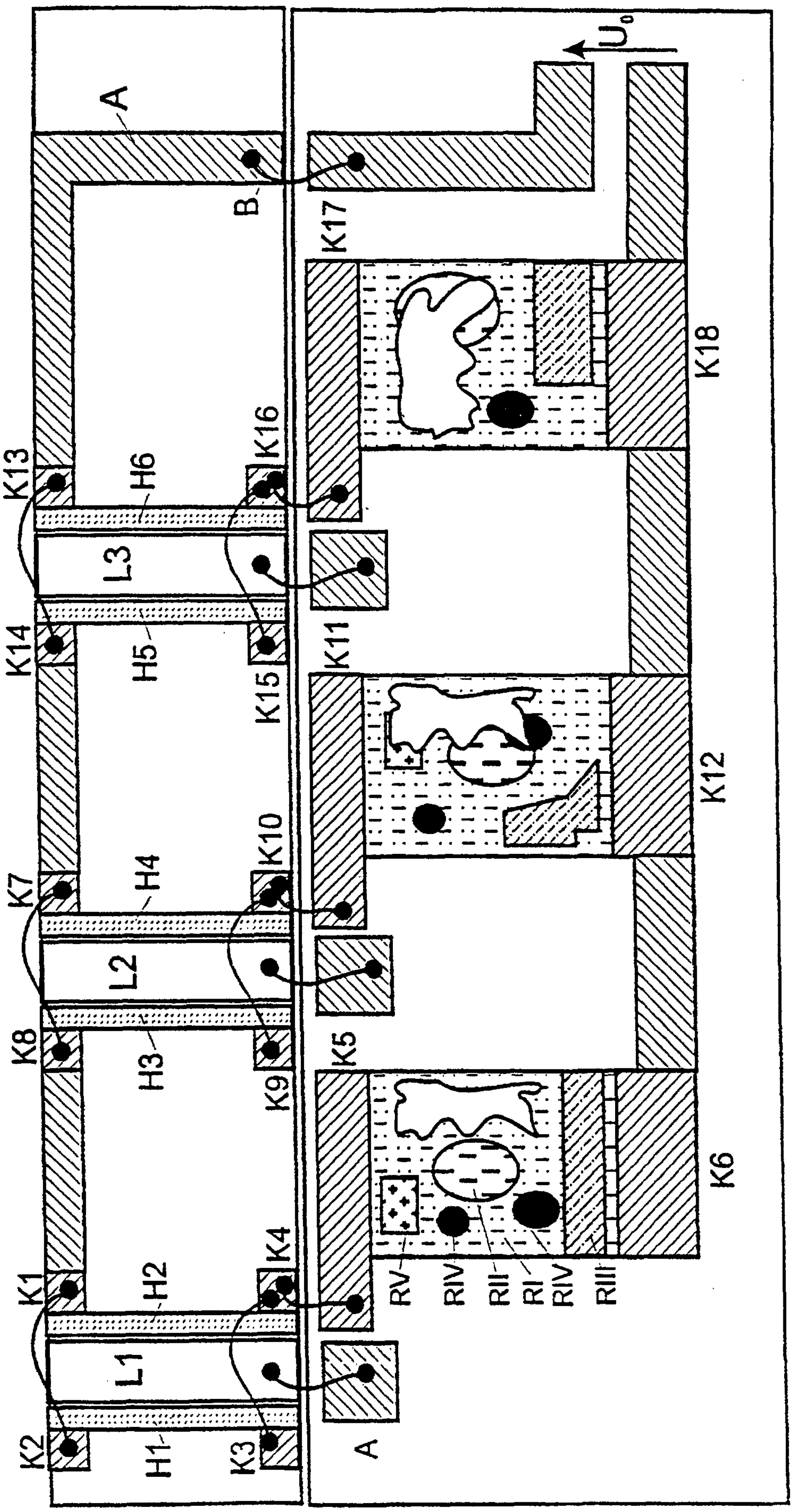
A
B
K1
K2
K3
K4
K5
K6
K7
K8
K9
K10
K11
K12
K13
K14
K15
K16
K17
K18
H1
H2
H3
H4
H5
H6
L1
L2
L3
RV
RIV
RII
RI
RIV
RIII
$U_0$

Fig. 8

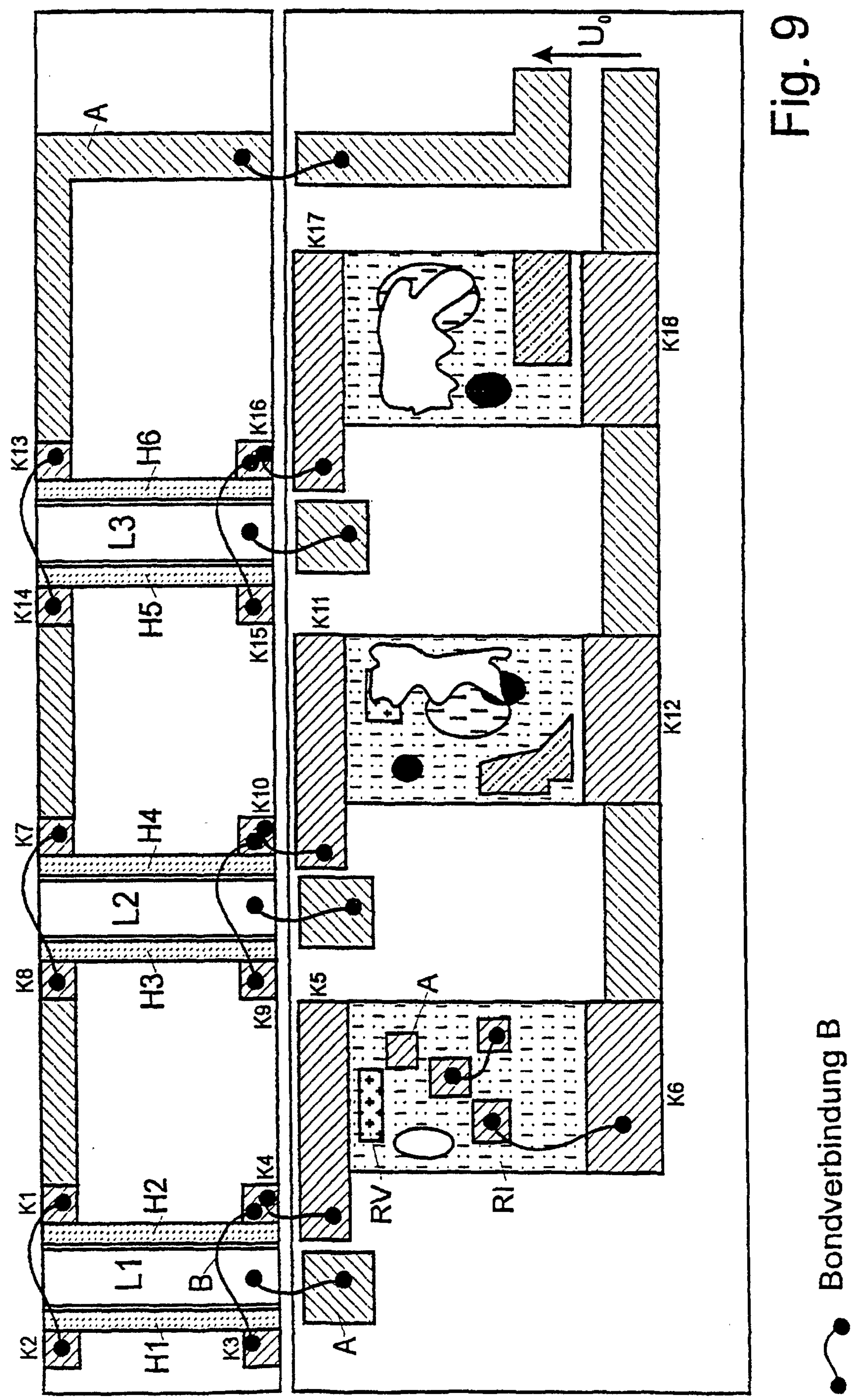
A
U0
K17
K18
K13
H6
K16
L3
K14
H5
K15
K11
K12
K7
H4
K10
L2
K8
H3
K9
K5
A
K6
K1
H2
K4
RV
RI
L1
B
K2
H1
K3
A
Bondverbindung B

Fig. 9

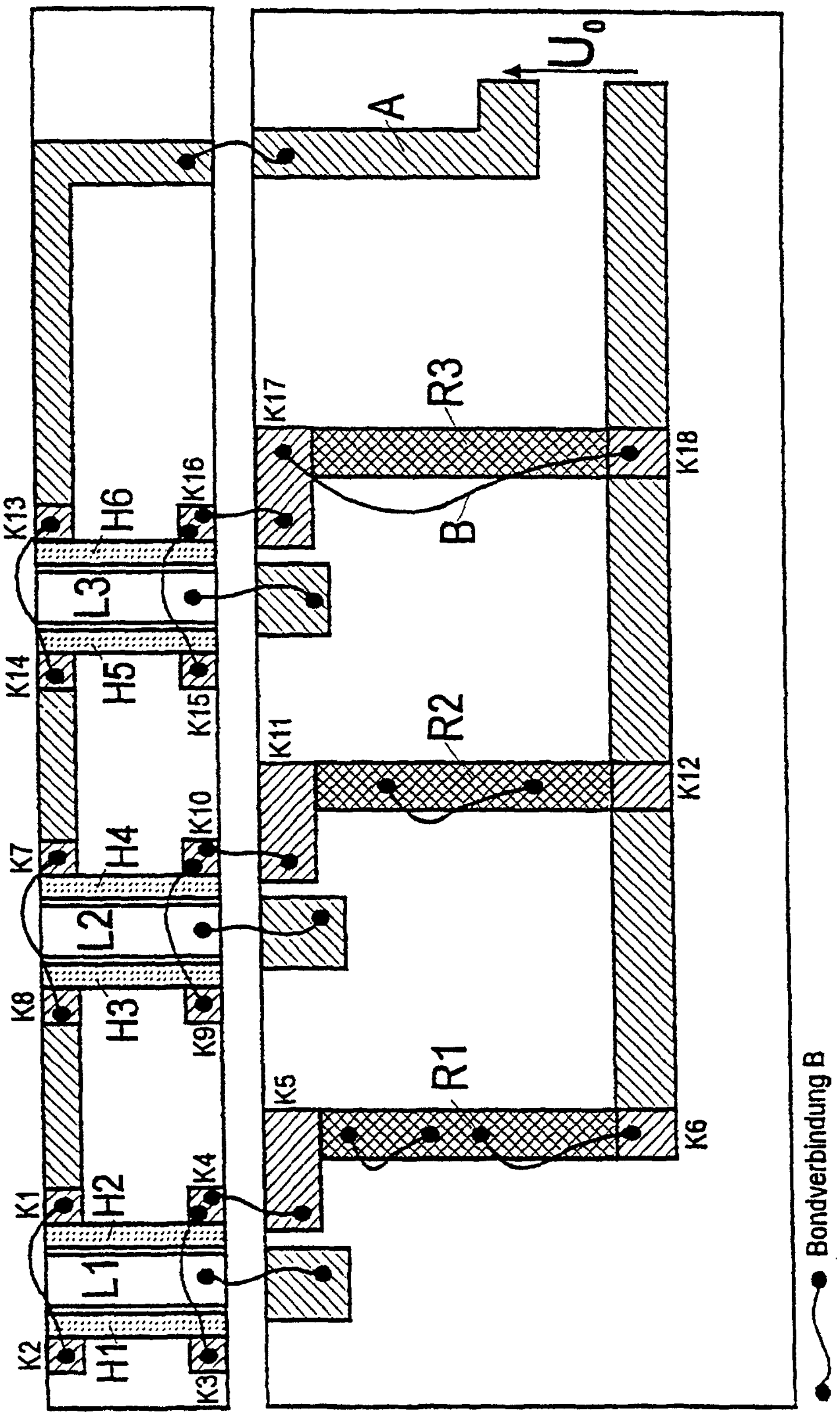
K1
K2
K3
K4
K5
K6
K7
K8
K9
K10
K11
K12
K13
K14
K15
K16
K17
K18
H1
H2
H3
H4
H5
H6
L1
L2
L3
R1
R2
R3
A
B
$U_0$
Bondverbindung B

Fig. 10

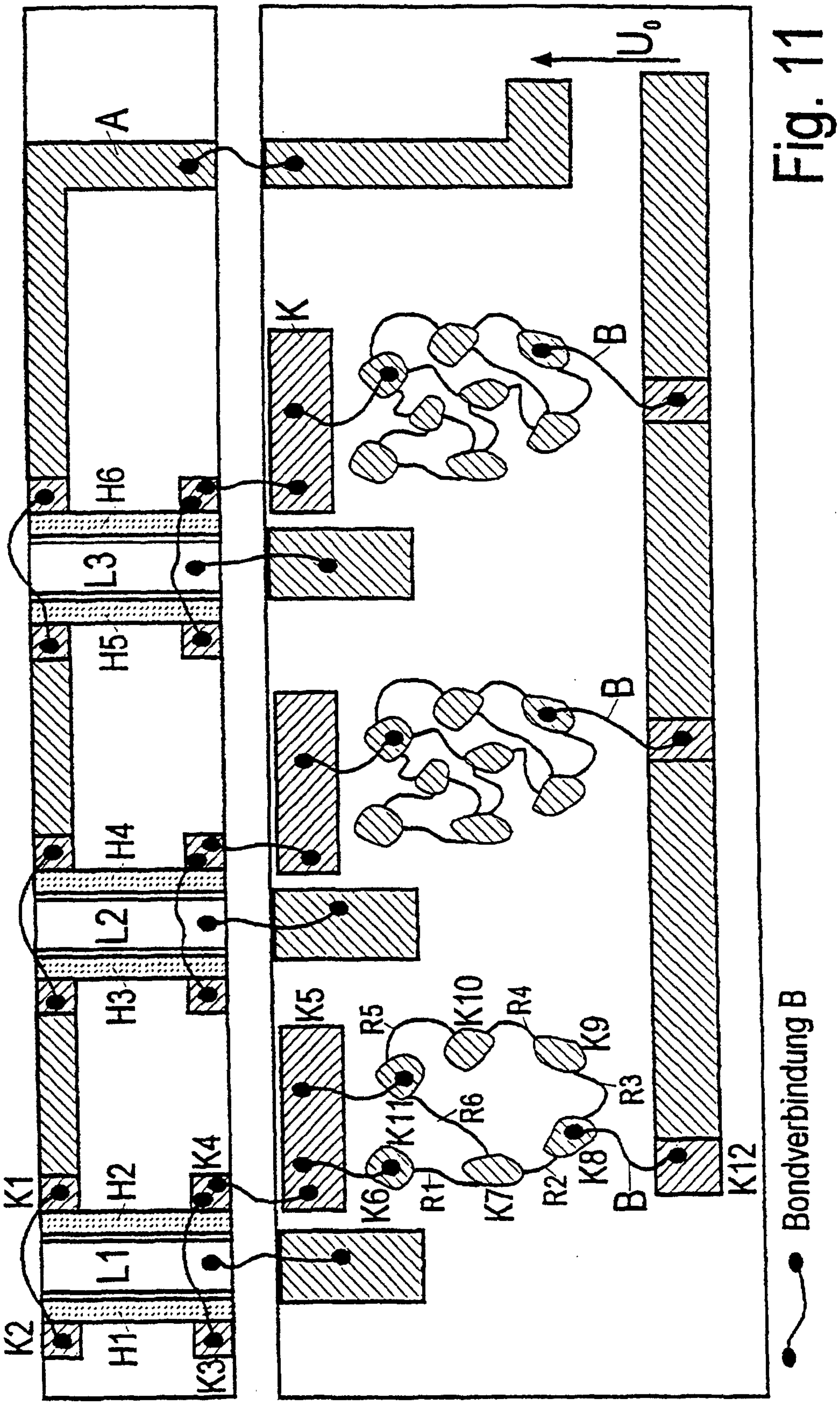
A
K
B
B
U0
H1
H2
H3
H4
H5
H6
L1
L2
L3
K1
K2
K3
K4
K5
K6
K7
K8
K9
K10
K11
K12
R1
R2
R3
R4
R5
R6
B
Bondverbindung B

Fig. 11

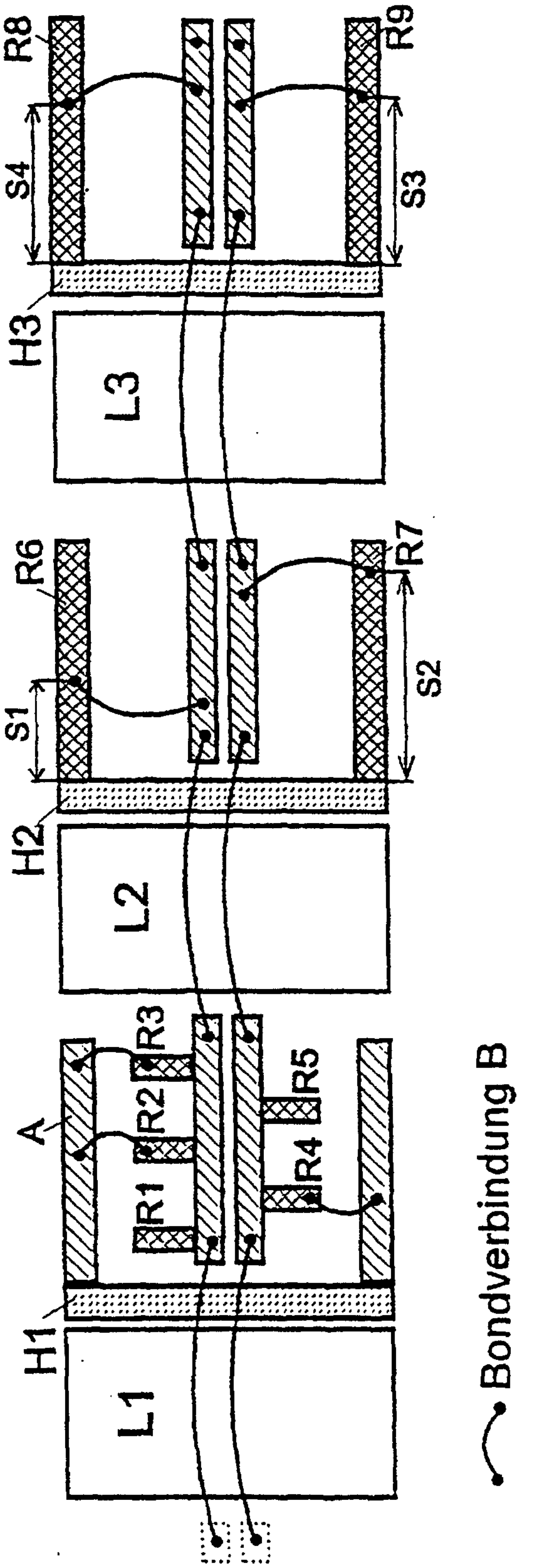
R8
R9
S4
S3
H3
L3
R6
R7
S1
S2
H2
L2
A
R1
R2
R3
R4
R5
H1
L1
Bondverbindung B

Fig. 12a

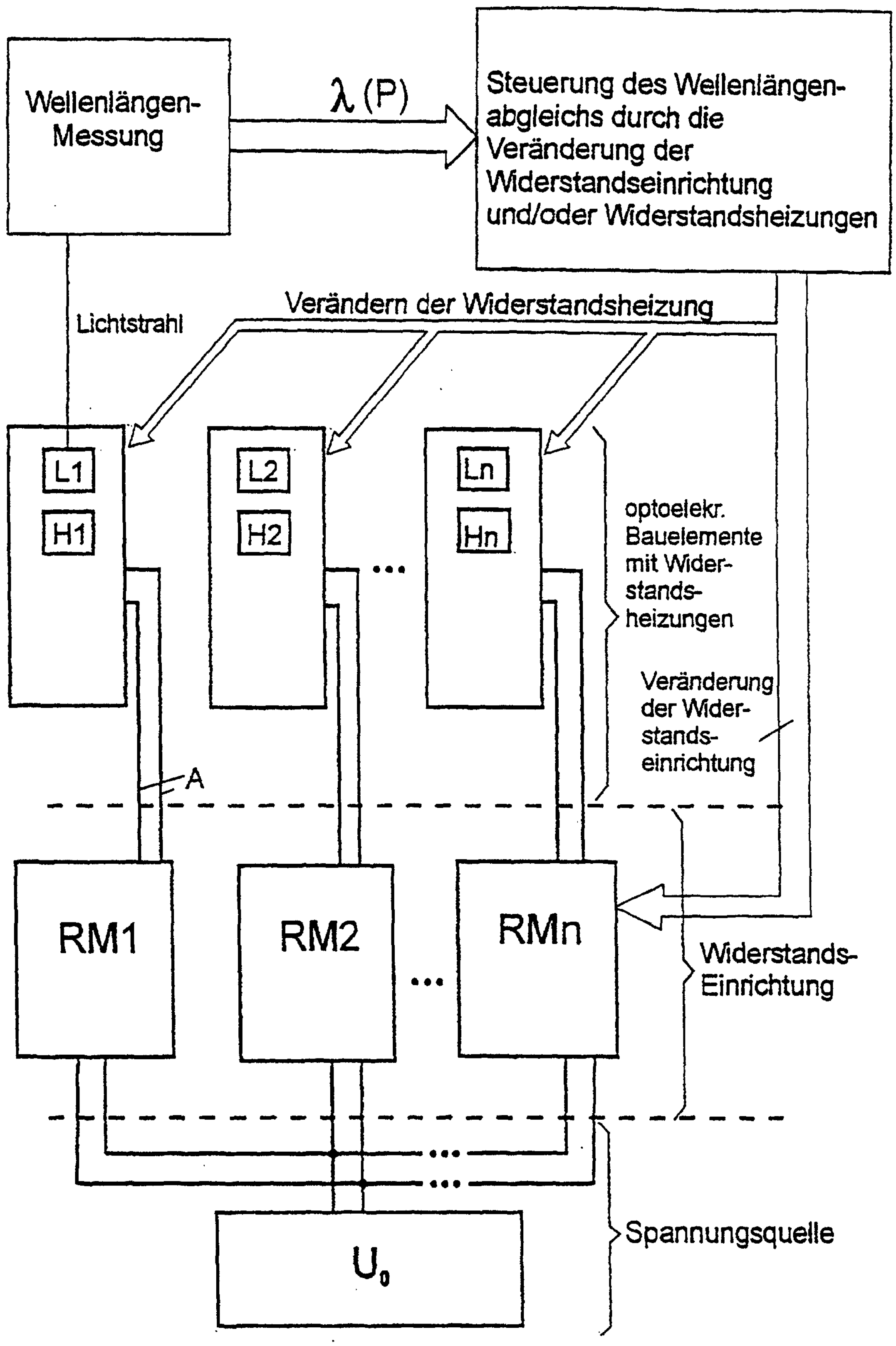
Wellenlängen-Messung
λ (P)
Steuerung des Wellenlängen-abgleichs durch die Veränderung der Widerstandseinrichtung und/oder Widerstandsheizungen
Verändern der Widerstandsheizung
Lichtstrahl
L1
H1
L2
H2
Ln
Hn
optoelekr. Bauelemente mit Wider-stands-heizungen
Veränderung der Wider-stands-einrichtung
A
RM1
RM2
RMn
Widerstands-Einrichtung
Spannungsquelle
U0

Fig. 12b

# Ausführungsbeispiel mit Stromquelle

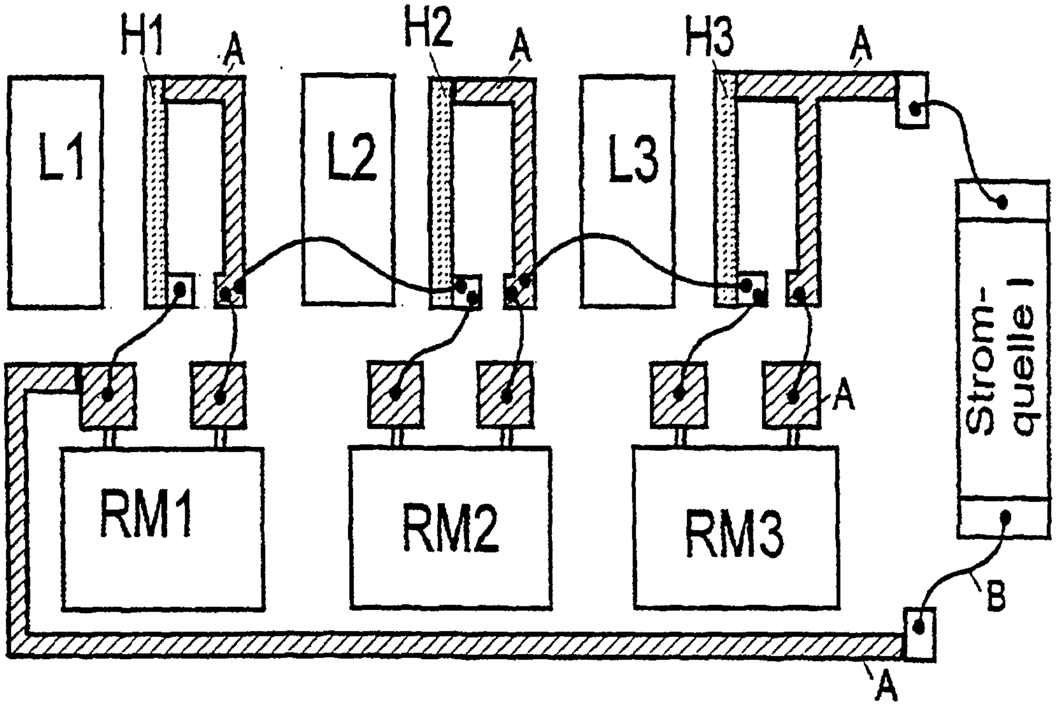


- elektrische Schaltung für Ausführungsbeispiel:

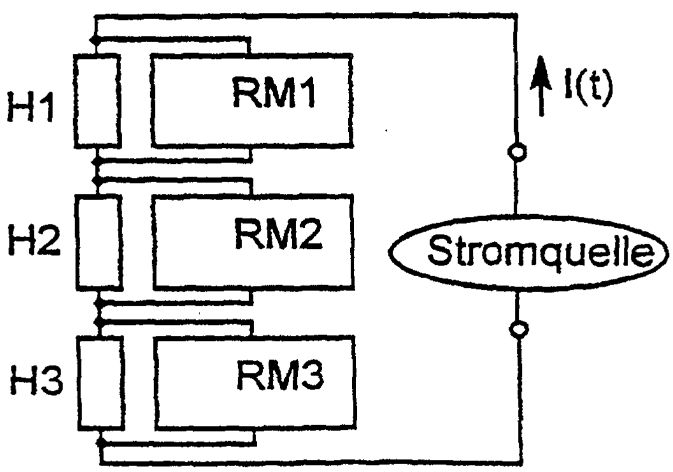


Fig.13